(19) Europäisches Patentamt
European Patent Office
Office européen des brevets

(11) **EP 4 254 388 A1**

(12) **EUROPEAN PATENT APPLICATION**
published in accordance with Art. 153(4) EPC

(43) Date of publication:
**04.10.2023 Bulletin 2023/40**

(51) International Patent Classification (IPC):
***G09G 3/32*** *(2016.01)*

(21) Application number: **20966453.1**

(52) Cooperative Patent Classification (CPC):
**G09G 3/32**

(22) Date of filing: **24.12.2020**

(86) International application number:
**PCT/CN2020/138928**

(87) International publication number:
**WO 2022/133881 (30.06.2022 Gazette 2022/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **LUO, Kun**
**Shenzhen, Guangdong 518129 (CN)**
• **JIANG, Congbiao**
**Shenzhen, Guangdong 518129 (CN)**
• **LIU, Yang**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **PIXEL STRUCTURE AND DISPLAY PANEL**

(57) A pixel structure is provided, where the pixel structure is used in a self-luminous display panel. The pixel structure includes: a plurality of subpixels. At least one subpixel in the plurality of subpixels includes a plurality of sub-subpixels, and a partition layer is arranged between two adjacent sub-subpixels. Light emission of the plurality of sub-subpixels is separately and independently controlled. In a case of a low display gray scale, density of a current flowing through a light emitting device is low, and only some sub-subpixels are controlled to emit light. Because a light emitting area of a sub-subpixel is smaller than a light emitting area of a subpixel, a current density of the sub-subpixel is greater than a current density of the subpixel. When the current density is large, stability of a light emitting spectrum is better, and color display is more accurate. In addition, because the current density is increased, impact of electric leakages on uneven display is reduced, and a problem of uneven display is greatly alleviated.

FIG. 1

EP 4 254 388 A1

## Description

## TECHNICAL FIELD

This application relates to the display field, and in particular, to a pixel structure and a display panel.

## BACKGROUND

A liquid crystal display (Liquid crystal display, LCD) requires a backlight source of white light. Luminance of light passing through the liquid crystal is controlled by controlling an angle of the liquid crystal based on a voltage. A display principle of the LCD determines that light emitted by the LCD is directional. The LCD has a normal luminance when being viewed in a vertical direction, but color cast of a large visual angle occurs when the LCD is viewed in a side view. Pixels of a self-luminous display panel include a self-luminous device whose emitted light is distributed in a same rule at different angles, and no color cast occurs when the self-luminous display panel is viewed in a side view. Therefore, the self-luminous display panel has advantages such as a high contrast, a wide color gamut, and a wide visual angle. For example, an active matrix organic light emitting diode (Active matrix organic light emitting diode, AMOLED) display panel is in a foldable flexible form, and the AMOLED display panel is widely used in mobile phones. However, in a case of a low display gray scale, problems such as display color cast and uneven display may occur on the self-luminous display panel, affecting user experience.

## SUMMARY

Embodiments of this application provide a pixel structure and a display panel, to alleviate problems of display color cast and uneven display on a self-luminous display panel at a low gray scale.

According to a first aspect, this embodiment of this application provides a pixel structure, and the pixel structure is used in a self-luminous display panel. The pixel structure includes: a plurality of subpixels, where at least one subpixel in the plurality of subpixels includes a plurality of sub-subpixels, and a partition layer is arranged between two adjacent sub-subpixels in the at least one subpixel. Light emission of the plurality of sub-subpixels is separately and independently controlled.

The self-luminous display panel includes a self-luminous device, such as an organic light emitting diode (organic light emitting diode, OLED) and a light emitting diode LED. Stability of a light emitting spectrum of the light emitting device such as the OLED and the LED is related to density of a current flowing through the light emitting device. When the density of the current flowing through the light emitting device is low, the light emitting spectrum of the light emitting device is unstable, and the display panel is prone to color cast. It should be understood that, the current density is a ratio of a drive current to a light emitting area of the light emitting device. Further, both the OLED and the LED devices have electric leakages of different degrees, and there is no obvious regularity for the electric leakages. Therefore, effective currents flowing through the light emitting devices are uneven, resulting in uneven display luminance of the display panel. When a current injected into the pixel is small, the problem of uneven display caused by electric leakages is further aggravated. In this embodiment of this application, the subpixel is divided into the plurality of sub-subpixels, and the light emission of each sub-subpixel may be separately and independently controlled. Therefore, a light emitting area of the subpixel is controllable, so that the light emitting area of the subpixel may be adjusted based on a value of a display gray scale. It should be understood that, the display gray scale is in a correlation with the density of the current flowing through the light emitting device, and a lower display gray scale corresponds to a smaller current density. For example, in a case of a low display gray scale, the density of the current flowing through the light emitting device is low, and only some sub-subpixels are controlled to emit light. Because a light emitting area of the sub-subpixel is smaller than the light emitting area of the subpixel, a current density of the sub-subpixel is greater than a current density of the subpixel. When the current density is large, stability of a light emitting spectrum of the pixel is better, and color display is more accurate. In addition, because the current density is increased, impact of the electric leakages on the uneven display is reduced, and the problem of uneven display is greatly alleviated. Therefore, by the pixel structure provided in this embodiment of this application, the problems of display color cast and uneven display that exist in low-gray-scale display can be alleviated.

In a possible implementation, the partition layer is configured to block transverse current crosstalk between the two adjacent sub-subpixels.

In a possible implementation, a material of the partition layer includes a photoresist.

In a possible implementation, the self-luminous display panel includes: a Micro LED display panel, an OLED display panel, an AMOLED display panel, or a passive matrix organic light emitting diode (Passive matrix organic light emitting diode, PMOLED) display panel.

In a possible implementation, the plurality of subpixels include: red (red, R) subpixels, green (green, G) subpixels, or blue (blue, B) subpixels.

In a possible implementation, the plurality of subpixels may be distributed in the following manners: RGB distribution, RGBG distribution, or RGB delta distribution.

In a possible implementation, a first subpixel includes a first sub-subpixel and a second sub-subpixel, the first subpixel is any subpixel in the plurality of subpixels, and a light emitting area of the first sub-subpixel is less than a light emitting area of the second sub-subpixel. The first sub-subpixel emits light, or the second sub-subpixel emits light, or both the first sub-subpixel and the second sub-subpixel emit light.

In a possible implementation, a first subpixel includes a first sub-subpixel and a second sub-subpixel, the first subpixel is any subpixel in the plurality of subpixels, and a light emitting area of the first sub-subpixel is less than a light emitting area of the second sub-subpixel. When a display gray scale of the first subpixel is less than a first threshold, the first sub-subpixel is controlled to emit light.

It should be understood that, when the display gray scale of the subpixel is lower than the first threshold, the current density corresponding to the subpixel is very small, the light emitting spectrum of the subpixel is unstable, and the problems such as display color cast and uneven display occur. In this case, the first sub-subpixel with a smaller light emitting area in the plurality of sub-subpixels is controlled to be turned on and emit light. Because the light emitting area of the first sub-subpixel is small, a current density of the first sub-subpixel is multiplied, and the light emitting spectrum is more stable, so that display color cast can be effectively reduced.

In a possible implementation, when the display gray scale of the first subpixel is greater than or equal to the first threshold and is less than a second threshold, the second sub-subpixel is controlled to emit light. The second threshold is greater than the first threshold. When the display gray scale of the first subpixel is greater than or equal to the second threshold, both the first sub-subpixel and the second sub-subpixel are controlled to emit light.

In a case in which one subpixel includes two sub-subpixels, when the lighting area of the subpixel is controlled based on the display gray scale, the display gray scale is divided into three segments based on the following rule: less than the first threshold, between the first threshold and the second threshold, and greater than the second threshold. Correspondingly, there may be three solutions for controlling the light emitting area of the subpixel: lighting only a sub-subpixel with a smaller light emitting area, lighting only a sub-subpixel with a larger light emitting area, or lighting both sub-subpixels. When the display gray scale of the subpixel is lower than the first threshold, the current density corresponding to the subpixel is very small, the light emitting spectrum of the subpixel is unstable, and the problems such as display color cast and uneven display occur. In this case, the first sub-subpixel with a smaller light emitting area in the plurality of sub-subpixels is controlled to be turned on and emit light. Because the light emitting area of the first sub-subpixel is small, a current density of the first sub-subpixel is multiplied, and the light emitting spectrum is more stable, so that display color cast can be effectively reduced. When the display gray scale of the subpixel is greater than or equal to the first threshold and is less than the second threshold, if a sub-subpixel with a smallest light emitting area is driven to emit light, a current density of the subpixel may exceed a rated current and the subpixel is burned. However, if the entire subpixel is lit (in other words, the subpixel is driven to emit light in a full area), the display spectrum may still unstable. In this case, the second sub-subpixel with a larger light emitting area may be lit, thereby increasing the current density of the light emitting diode, improving stability of the light emitting spectrum, reducing display color cast, and additionally, ensuring that the current density of the diode does not exceed the rated current, to avoid burning the diode. When the display gray scale of the subpixel is greater than the second threshold, the light emitting spectrum of the subpixel tends to be stable, and a displayed color is accurate and even. In this case, all sub-subpixels are controlled to emit light, to ensure that the current density of each sub-subpixel is within the rated range, thereby lighting the subpixel in a full area, and improving display efficiency of the subpixel.

In a possible implementation, the first subpixel includes a plurality of sub-subpixels, light emitting areas of the plurality of sub-subpixels successively increase. When the display gray scale of the first subpixel is less than the first threshold, the sub-subpixel with a smallest light emitting area in the plurality of sub-subpixels is controlled to emit light.

It should be understood that, in this embodiment of this application, light emitting areas of a plurality of sub-subpixels included in one subpixel are usually designed to be gradient. In other words, the light emitting areas of the plurality of sub-subpixels successively increase. When the display gray scale input to the subpixel is very low, only the sub-subpixel with a smallest light emitting area is controlled to be turned on and emit light, so that the current density of the light emitting diode can be effectively increased, the light emitting diode can have a stable light emitting spectrum when the input display gray scale is low, and the display color cast is reduced.

In a possible implementation, the first subpixel is a G subpixel, and the first threshold is 32.

It should be understood that, when the display gray scale of the subpixel is lower than the first threshold, the light emitting spectrum of the subpixel is unstable, and display color cast occurs. Different types of subpixels have different first thresholds corresponding to an occurrence of display color cast. For example, first thresholds corresponding to the occurrence of display color cast of the R subpixel, the G subpixel, and the B pixel are different. In addition, different types of display panels or a same type of display panels produced by different manufacturers may also have different first thresholds corresponding to the occurrence of display color cast.

In a possible implementation, the first subpixel is a G subpixel, and the second threshold is 64.

It should be understood that, when the gray scale input into the subpixel is greater than the second threshold, the light emitting spectrum of the subpixel tends to be stable, and a displayed color is accurate and even. Different types of subpixels correspond to different second thresholds. For example, the R subpixel, the G subpixel, and the B pixel correspond to different second thresholds. In addition, different types of display panels or a same type of display panels produced by different manufacturers may also have different second thresholds.

In a possible implementation, the first subpixel includes three sub-subpixels, light emitting areas of the three sub-subpixels successively increases from a first sub-subpixel to a third sub-subpixel. When the display gray scale of the first subpixel is lower than a first threshold, the first sub-subpixel is controlled to be turned on and emit light. When the display gray scale of the first subpixel is greater than or equal to the first threshold and is less than a second threshold, the second sub-subpixel is controlled to be turned on and emit light. When the display gray scale of the first subpixel is greater than or equal to the second threshold and is less than a third threshold, the third sub-subpixel is controlled to be turned on and emit light. When the display gray scale of the first subpixel is greater than or equal to the third threshold, all three sub-subpixels are controlled to emit light.

It should be understood that, when the subpixel includes more sub-subpixels, and the lighting area of the subpixel is controlled based on the display gray scale, the display gray scale may be divided into more segments. Correspondingly, there are more solutions for controlling the light emitting area of the subpixel. More detailed division levels of the display gray scale, more flexible and smooth control on display effect.

In a possible implementation, an included angle between a side surface of the partition layer and a first plane is less than or equal to 90 degrees, and the first plane is parallel to a plane in which a surface of the pixel structure is located.

It should be understood that, because the included angle between the side surface of the partition layer and a substrate plane is less than or equal to 90 degrees. In other words, the partition layer is in an inverted trapezoidal shape with a cross-section gradually increasing in a height direction, a width of an upper surface of the partition layer is greater than a width of a lower surface. The upper surface is a plane away from the substrate, and the lower surface is a plane close to the substrate. During vapor deposition of an organic light-emitting material, a continuous thin film cannot be formed during vapor deposition of the organic light-emitting material due to shielding of the upper surface of the partition layer. The organic light-emitting layer includes a hole injection layer with a high conductivity, and a width of the partition layer is usually only 1 $\mu$m to 2 $\mu$m, if a continuous thin film structure is formed, there may be transverse current crosstalk in the hole injection layers on both sides of the partition layer. Therefore, in this embodiment of this application, the included angle between the side surface of the partition layer and the substrate plane is less than or equal to 90 degrees, and a continuous thin film cannot be formed during vapor deposition of the organic light-emitting material, so that a distance between the hole injection layers on both sides of the partition layer is increased, and transverse current crosstalk is avoided in the hole injection layers on both sides of the partition layer.

In a possible implementation, a pixel definition layer is arranged between two adjacent subpixels, and an included angle between a side surface of the pixel definition layer and the first plane is greater than 90 degrees.

Because the angle between the pixel definition layer and the substrate plane is greater than 90 degrees, a continuous thin film structure can be formed during vapor deposition of the organic light-emitting material. A width of the pixel definition layer is usually 20 $\mu$m to 40 $\mu$m. Even if the continuous thin film structure is formed during vapor deposition of the organic light-emitting material, the hole injection layers on two adjacent sides of the pixel definition layer has a large resistance, and the formed transverse current crosstalk is very weak and may be ignored basically. In addition, continuity and integrity of a cathode are not destroyed, and conductivity of a whole surface of the cathode is ensured.

In a possible implementation, the pixel structure further includes a substrate layer, and the first plane is parallel to an upper surface of the substrate layer. The drive layer is arranged on the upper surface of the substrate layer, and the anode layer is arranged on an upper surface of the drive layer.

In a possible implementation, each sub-subpixel in the plurality of sub-subpixels includes an anode layer, an organic light emitting layer, and a cathode layer, and the organic light emitting layer is located between the anode layer and the cathode layer. The partition layer is arranged between anode layers of two adjacent sub-subpixels. The partition layer is arranged between organic light emitting layers of two adjacent sub-subpixels. The plurality of sub-subpixels share a same cathode layer.

In a possible implementation, the self-luminous display panel is a micro LED display panel, each sub-subpixel in the plurality of sub-subpixels includes a cathode layer, an organic light emitting layer, and an anode layer, and the organic light emitting layer is located between the anode layer and the cathode layer. The partition layer is arranged between cathode layers of two adjacent sub-subpixels. The partition layer is arranged between organic light emitting layers of two adjacent sub-subpixels. The plurality of sub-subpixels share a same anode layer.

In a possible implementation, the pixel structure further includes: a drive layer, where a drive circuit is arranged on the drive layer, each subpixel in the plurality of subpixels corresponds to one drive circuit, and the drive circuit is configured to separately and independently control the plurality of sub-subpixels to emit light. The drive circuit includes a plurality of branch switches, a quantity of the plurality of branch switches is equal to a quantity of sub-subpixels included in one subpixel, and one branch switch corresponds to one sub-subpixel. Each sub-subpixel in the plurality of sub-subpixels includes a light emitting diode, and the branch switch is configured to control on or off of a light emitting diode in a corresponding sub-subpixel.

It should be understood that, the plurality of branch switches are arranged in the drive layer, and the light emitting diode is arranged in the anode layer, the organic light emitting layer, and the cathode layer. It should be understood that, one branch switch may include one or more switching transistors. A quantity of switching transistors included in the branch switch is not limited in this embodiment of this application.

In a possible implementation, the plurality of branch switches include a first branch switch and a second branch switch, the first branch switch corresponds to a first light emitting diode, and the second branch switch corresponds to a second light emitting diode. When the first branch switch is turned on, the first light emitting diode is turned on, and when the second branch switch is turned on, the second light emitting diode is turned on.

In a possible implementation, the branch switch is connected in series to a branch of a corresponding light emitting diode, and the branch switch is specifically configured to receive a control signal, and be turned on or off under an effect of the control signal, so that the light emitting diode of the branch in which the branch switch is located is turned on or off.

In a possible implementation, the plurality of branch switches are connected in parallel, the drive circuit further includes a main switch, after being connected in parallel, the plurality of branch switches are connected in series to the main switch, the main switch is connected to an input end of the drive circuit, when a drive voltage is input to the input end, the main switch is turned on, and the drive voltage corresponds to a display gray scale of a subpixel corresponding to the drive circuit.

In a possible implementation, the plurality of branch switches are connected to a plurality of control lines in a one-to-one correspondence, and the plurality of branch switches receive control signals from scan control lines respectively corresponding to the plurality of branch switches, and are turned on or off under an effect of the control signals.

It should be understood that, one main switch may include one or more switching transistors. A quantity of switching transistors included in the main switch is not limited in this embodiment of this application.

In a possible implementation, a spacing between anodes of two adjacent sub-subpixels is 1 $\mu$m to 2 $\mu$m.

It should be understood that, the spacing between anodes of two adjacent sub-subpixels needs to be greater than or equal to 1 $\mu$m, and a spacing between two adjacent sub-subpixels is greater than the spacing between anodes of two adjacent sub-subpixels. The spacing between two adjacent sub-subpixels is a width of a part that is between two adjacent light emitting bodies and that does not emit light after the two adjacent subpixels are lit. The partition layer is in an inverted trapezoidal shape with a gradually increasing cross section in a height direction, an area of the organic light emitting layer of a sub-subpixel is smaller than an area of the anode of the sub-subpixel, and a light emitting area of the sub-subpixel depends on an overlapping area of the organic light emitting layer and the anode layer of the sub-subpixel. Therefore, a light emitting area of the sub-subpixel is slightly smaller than the area of the anode of the sub-subpixel.

In a possible implementation, the first sub-subpixel corresponds to a first anode, the second sub-subpixel corresponds to a second anode, and a ratio of an area of the first anode to an area of the second anode is 1 to 10.

It should be understood that, if the ratio of areas of the two anodes is excessively large, the area of the second anode is excessively small, and preparation difficulty is increased. If the ratio of areas of the two anodes is excessively small, display effect at a low gray scale is poor. The ratio of the area of the first anode to that of the second anode may be an integer or a decimal.

According to a second aspect, an embodiment of this application provides a self-luminous display panel, including the pixel structure in the first aspect or any possible implementation of the first aspect.

In a possible implementation, the self-luminous display panel further includes a display driver integrated circuit (Display Driver Integrated Circuits, DDIC).

According to a third aspect, an embodiment of this application provides a display control apparatus. The display control apparatus is configured to control a pixel structure in a self-luminous display panel, the pixel structure includes a plurality of subpixels, and each subpixel of the plurality of subpixels includes a plurality of sub-subpixels. The display control apparatus includes: a processor and a transmission interface. The processor is configured to generate at least one control signal. The processor is further configured to control the transmission interface to send the at least one control signal to a first subpixel, where the first subpixel is any subpixel in the plurality of subpixels. The at least one control signal indicates to control one or more sub-subpixels in a plurality of sub-subpixels included in the first subpixel to emit light.

It should be understood that, the display control apparatus provided in this embodiment of this application may generate different control signals, to control a plurality of sub-subpixels included in a subpixel to separately and independently emit light. For example, a control signal for controlling a first sub-subpixel to emit light is generated, a control signal for controlling a second sub-subpixel to emit light is generated, or a control signal for controlling some sub-subpixels or all sub-subpixels to emit light is generated.

In a possible implementation, the processor is further configured to determine whether a display gray scale of the first subpixel is less than a first threshold.

When the processor determines that the display gray scale of the first subpixel is less than the first threshold, the processor is specifically configured to: generate a first control signal, where the at least one control signal includes the first control signal. The processor is further configured to control the transmission interface to send the first control signal to the first subpixel, the first control signal indicates to control a first sub-subpixel to emit light, and the first sub-subpixel is a sub-subpixel with a smallest light emitting area in the plurality of sub-subpixels included in the first subpixel.

It should be understood that, when the display gray scale of the subpixel is lower than the first threshold, a current density corresponding to the subpixel is very small, a light emitting spectrum of the subpixel is unstable, and problems such as display color cast and uneven display occur. In this embodiment of this application, light emitting areas of a plurality of sub-subpixels included in one subpixel are usually designed to be gradient. In other words, the light emitting areas of the plurality of sub-subpixels successively increase. When the display gray scale input to the subpixel is very low, only the sub-subpixel with a smallest light emitting area is controlled to be turned on and emit light, so that the current density of the light emitting diode can be effectively increased, the light emitting diode can have a stable light emitting spectrum when the input display gray scale is low, and the display color cast is reduced.

In a possible implementation, the first subpixel includes the first sub-subpixel and a second sub-subpixel, a light emitting area of the second sub-subpixel is greater than the light emitting area of the first sub-subpixel. When determining that the display gray scale of the first subpixel is greater than or equal to a first threshold and is less than the second threshold, the processor is specifically configured to: generate a second control signal, where the at least one control signal includes the second control signal. The processor is further configured to control the transmission interface to send the second control signal to the first subpixel, and the second control signal indicates to control the second sub-subpixel to emit light. The second threshold is greater than the first threshold.

When the display gray scale of the subpixel is greater than or equal to the first threshold and is less than the second threshold, if a sub-subpixel with a smallest light emitting area is driven to emit light, a current density of the subpixel may exceed a rated current and the subpixel is burned. However, if the entire subpixel is lit (in other words, the subpixel is driven to emit light in a full area), the display spectrum may still unstable. In this case, the second sub-subpixel with a larger light emitting area may be lit, thereby increasing the current density of the light emitting diode, improving stability of the light emitting spectrum, reducing display color cast, and additionally, ensuring that the current density of the diode does not exceed the rated current, to avoid burning the diode.

In a possible implementation, the first control signal indicates to turn off a switch corresponding to another sub-subpixel other than the first sub-subpixel, and the second control signal is for turning off a switch corresponding to another sub-subpixel other than the second sub-subpixel.

It should be understood that, when switches corresponding to the plurality of sub-subpixels are turned on by default, and the processor detects that the display gray scale input into the subpixel is lower than the first threshold, the first control signal is sent to turn off another sub-subpixel other than the sub-subpixel with a smallest light emitting area. When the processor detects that the display gray scale is greater than or equal to the first threshold and is less than the second threshold, the second control signal is sent to turn off another sub-subpixel other than the second sub-subpixel. When the processor detects that the display gray scale is greater than the second threshold, no control signal is sent, and the switches corresponding to the plurality of sub-subpixels are all turned on.

In a possible implementation, when determining that the display gray scale of the first subpixel is greater than or equal to the second threshold, the processor is specifically configured to: generate a third control signal, where the at least one control signal includes the third control signal. The processor is further configured to control the transmission interface to send the third control signal to the first subpixel, and the third control signal indicates to control all the plurality of sub-subpixels to emit light.

In a possible implementation, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

In a possible implementation, the self-luminous display panel includes an organic light emitting diode OLED display panel, an active matrix organic light emitting diode AMOLED display panel, or a micro light emitting diode micro LED display panel.

According to a fourth aspect, an embodiment of this application provides a display control method. The method is used to control a pixel structure in a self-luminous display panel, the pixel structure includes a plurality of subpixels, and each subpixel of the plurality of subpixels includes a plurality of sub-subpixels. The method includes: generating at least one control signal; sending the at least one control signal to a first subpixel, where the first subpixel is any subpixel in the plurality of subpixels. The at least one control signal indicates to control one or more sub-subpixels in a plurality of sub-subpixels included in the first subpixel to emit light.

It should be understood that, beneficial effects of the display control method in the fourth aspect are similar to beneficial effects of the display control apparatus in the third aspect, and details are not described herein again.

In a possible implementation, the method further includes: determining whether a display gray scale of the first subpixel is less than a first threshold; generating a first control signal when determining that the display gray scale of the first subpixel is less than the first threshold, where the at least one control signal includes the first control signal; and sending the first control signal to the first subpixel, where the first control signal indicates to control a first sub-subpixel to emit light, and the first sub-subpixel is a sub-subpixel with a smallest light emitting area in the plurality of sub-subpixels included in the first subpixel.

In a possible implementation, the first subpixel includes the first sub-subpixel and a second sub-subpixel, and a light emitting area of the second sub-subpixel is greater than the light emitting area of the first sub-subpixel. The method further includes: generating a second control signal when determining that the display gray scale of the first subpixel is greater than or equal to the first threshold and less than a second threshold, where the at least one control signal includes the second control signal; and sending the second control signal to the first subpixel, where the second control signal indicates to control the second sub-subpixel to emit light. The second threshold is greater than the first threshold.

In a possible implementation, the first control signal indicates to turn off a switch corresponding to another sub-subpixel other than the first sub-subpixel, and the second control signal is for turning off a switch corresponding to another sub-subpixel other than the second sub-subpixel.

In a possible implementation, the method further includes: generating a third control signal when determining that the display gray scale of the first subpixel is greater than or equal to the second threshold, where the at least one control signal includes the third control signal; and sending the third control signal to the first subpixel, where the third control signal indicates to control all the plurality of sub-subpixels to emit light.

In a possible implementation, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

In a possible implementation, the self-luminous display panel includes an organic light emitting diode OLED display panel, an active matrix organic light emitting diode AMOLED display panel, or a micro light emitting diode micro LED display panel.

In a possible implementation, the method includes: determining whether a display gray scale of a first subpixel is less than a first threshold, where the first subpixel is any subpixel in the plurality of subpixels; and sending the first control signal to the first subpixel when determining that the display gray scale of the first subpixel is less than the first threshold, where the first control signal indicates to control a first sub-subpixel to emit light, and the first sub-subpixel is a sub-subpixel with a smallest light emitting area in the plurality of sub-subpixels included in the first subpixel.

In a possible implementation, the first subpixel includes the first sub-subpixel and a second sub-subpixel, and a light emitting area of the second sub-subpixel is greater than the light emitting area of the first sub-subpixel. The method further includes: sending a second control signal to the first subpixel when determining that the display gray scale of the first subpixel is greater than or equal to the first threshold and is less than a second threshold, where the second control signal indicates to control the second sub-subpixel to emit light. The second threshold is greater than the first threshold.

In a possible implementation, the method further includes: sending a third control signal to the first subpixel when determining that the display gray scale of the first subpixel is greater than or equal to the second threshold, where the third control signal indicates to control all the plurality of sub-subpixels to emit light.

According to a fifth aspect, this application provides a display control apparatus. The apparatus includes a function module configured to implement the display control method in the fourth aspect and any possible implementation of the fourth aspect.

According to a sixth aspect, this application provides a terminal. The terminal includes the self-luminous display panel according to the second aspect and any possible implementation of the second aspect and the display control apparatus according to the third aspect and any possible implementation of the third aspect.

According to a seventh aspect, this application provides a computer-readable storage medium. The computer-readable storage medium stores instructions, and when the instructions are run on a computer or a processor, the computer or the processor is enabled to perform the method according to the fourth aspect or any possible implementation of the fourth aspect.

According to an eighth aspect, this application provides a computer program product including instructions. When the instructions are run on a computer or a processor, the computer or the processor is enabled to perform the method according to the fourth aspect or any possible implementation of the fourth aspect.

## BRIEF DESCRIPTION OF DRAWINGS

FIG. 1 is a schematic cross-sectional view of an example of a pixel structure according to an embodiment of this application;

FIG. 2 is a three-dimensional view of an example of a pixel structure according to an embodiment of this application;

FIG. 3 is a schematic cross-sectional view of an example of a pixel structure according to this application;

FIG. 4a is a schematic diagram of an anode layer of a pixel structure according to an embodiment of this application;

FIG. 4b is a schematic cross-sectional view of a pixel structure according to an embodiment of this application;

FIG. 5 is a schematic diagram of a principle of a drive circuit according to an embodiment of this application;

FIG. 6 is a schematic cross-sectional view of an example of a pixel structure according to an embodiment of this application;

FIG. 7a is an example of a display panel in RGB distribution according to an embodiment of this application;

FIG. 7b is an example of a display panel in RGBG distribution according to an embodiment of this application;

FIG. 7c is an example of a display panel in RGB delta distribution according to an embodiment of this application;

FIG. 8 is a schematic cross-sectional view of a pixel structure according to an embodiment of this application;

FIG. 9 shows a display control apparatus according to an embodiment of this application;

FIG. 10 is a flowchart of a display control method according to an embodiment of this application;

FIG. 11 is a flowchart of a display control method according to an embodiment of this application;

FIG. 12 is a schematic diagram of a structure of a display control apparatus according to an embodiment of this application; and

FIG. 13 is a simulation diagram of color coordinates of a green subpixel at a low display gray scale according to an embodiment of this application.

DESCRIPTION OF EMBODIMENTS

In embodiments of the specification, claims, and accompanying drawings of this application, the terms "first", "second", and the like are intended to distinguish between similar objects but do not necessarily indicate a specific order or sequence. In addition, the terms "include", "have", and any other variants thereof are intended to cover a non-exclusive inclusion, for example, include a series of steps or units. Methods, systems, products, or devices do not need to be limited to those steps or units that are clearly listed, but may include other steps or units that are not clearly listed or inherent to these processes, methods, products, or devices.

It should be understood that, in this application, "at least one" means one or more, and "a plurality of" means two or more. The term "and/or" is used to describe an association relationship for describing associated objects and represents that three relationships may exist. For example, A and/or B may represent the following three cases: Only A exists, only B exists, and both A and B exist, where A and B may be singular or plural. The character "/" generally indicates an "or" relationship between the associated objects. "At least one of the following" or a similar expression thereof refers to any combination of these items, including one item or any combination of a plurality of items. For example, at least one of a, b, or c may represent: a, b, c, "a and b", "a and c", "b and c", or "a, b, and c", where a, b, and c may be singular or plural.

A self-luminous display panel includes a self-luminous device, such as an OLED and an LED. Stability of a light emitting spectrum of the light emitting device such as the OLED and the LED is related to density of a current flowing through the light emitting device. When the density of the current flowing through the light emitting device is low, the light emitting spectrum of the light emitting device is unstable, and the display panel is prone to color cast. Further, both the OLED device and the LED device have electric leakages of different degrees, and there is no obvious regularity for the electric leakages. Therefore, effective currents flowing through the light emitting devices are uneven, resulting in uneven display luminance of the display panel. When a current injected into a pixel is small, the problem of uneven display caused by the electric leakages is further aggravated. In other words, in a case of a low display gray scale, problems such as display color cast and uneven display may occur on the self-luminous display panel in the conventional technology, affecting user experience. AMOLED display panels are widely used in smartphones. If problems of display color cast and uneven display on the AMOLED display panel at a low display gray scale may be resolved, user experience will be greatly improved and product competitiveness is improved. Embodiments of this application provide a pixel structure and a display panel, which may effectively alleviate the problems of display color cast and uneven display on the self-luminous display panel at the low gray scale.

When the AMOLED display panel is lit in a solid color, it should be understood that, lighting in a solid color indicates that a same display gray scale is input into each pixel in the display panel, and a luminance $L_{pixel}$ of any pixel in the display panel may be represented in a formula (1) or a formula (2):

$$L_{pixel} = \frac{L_{panel}}{AR} \qquad (1)$$

$$L_{pixel} = CE \cdot J_{pixel} \qquad (2)$$

$$AR = \frac{S_{Anode}}{S_{pixel}} \qquad (3)$$

$$J_{pixel} = \frac{I}{AR \cdot S_{pixel}} \qquad (4)$$

$L_{panel}$ indicates a luminance of the display panel, AR indicates a pixel aperture ratio, CE indicates a current efficiency of an OLED, and $J_{pixel}$ indicates a current density of a subpixel.

$S_{Anode}$ indicates an area of a light emitting anode, $S_{pixel}$ indicates an area of the subpixel, and the pixel aperture ratio AR is a ratio of the area of the light emitting anode to the area of the subpixel. I is a drive current of a drive circuit that drives the subpixel.

According to formulas (1), (2), and (4), the following equation may be obtained:

$$L_{panel} = CE \cdot \frac{I}{S_{pixel}} \qquad (5)$$

For a known display panel, both CE and $S_{pixel}$ are fixed values. Therefore, a luminance of the display panel depends on a value of the drive current I. When a display gray scale input into the subpixel is lower, the display luminance of the display panel is lower and a corresponding current density is smaller. However, when the current density is small, a light emitting spectrum of the OLED is offset, resulting in display color cast and uneven display. If the current density of the subpixels is increased, the problems of display color cast and uneven display on the self-luminous display panel at a low display gray scale can be effectively alleviated.

An embodiment of this application provides a pixel structure, and the pixel structure is used in a self-luminous display panel. The pixel structure includes: a plurality of subpixels, where at least one subpixel in the plurality of subpixels includes a plurality of sub-subpixels, and a partition layer is arranged between two adjacent sub-subpixels in the at least one subpixel. Light emission of the plurality of sub-subpixels is separately and independently controlled.

In an optional case, each subpixel in the pixel structure includes a plurality of sub-subpixels, or some subpixels in the pixel structure includes a plurality of sub-subpixels.

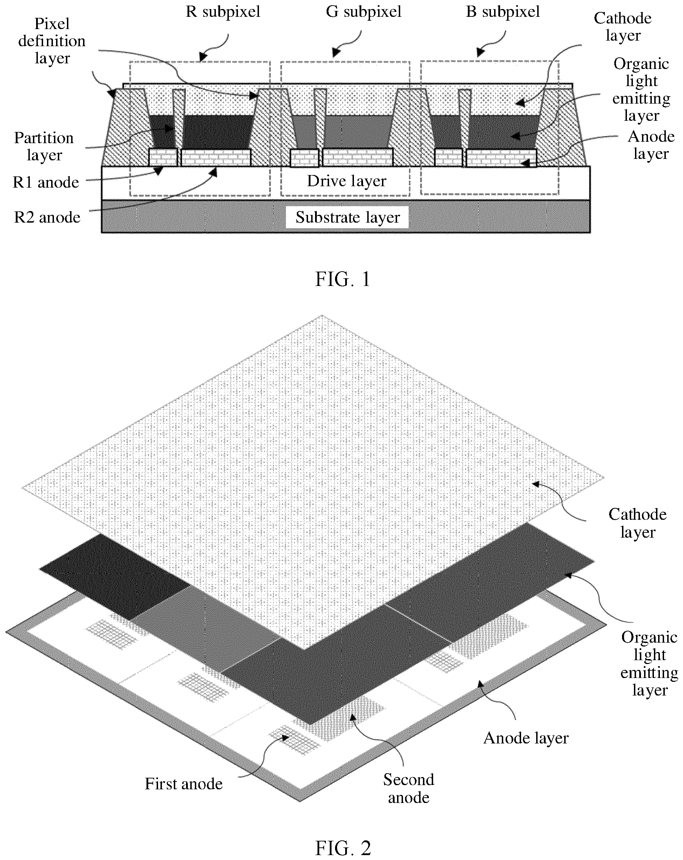

FIG. 1 is a schematic cross-sectional view of an example of a pixel structure according to an embodiment of this application, and FIG. 2 is a three-dimensional view of an example of a pixel structure according to an embodiment of this application. As shown in FIG. 1, the pixel structure includes: an R subpixel, a G subpixel, and a B subpixel. The R subpixel, the G subpixel, and the B subpixel are each divided into two subpixels, and a partition layer is arranged between the two adjacent subpixels. The R subpixel includes a first R sub-subpixel and a second R sub-subpixel, the G subpixel includes a first G sub-subpixel and a second G sub-subpixel, and the B subpixel includes a first B sub-subpixel and a second B sub-subpixel. Each sub-subpixel corresponds to one light emitting device, and a light emitting device included in an AMOLED pixel structure is an OLED.

It should be understood that, the R subpixel, the G subpixel, and the B subpixel have similar structures, and the following uses only the R subpixel as an example for description. The R subpixel includes a first sub-subpixel R1 and a second sub-subpixel R2. Both R1 and R2 include an anode layer, an organic light emitting layer, and a cathode layer. A partition layer is arranged between the anode layer of R1 and the anode layer of R2, and the partition layer is arranged between the organic light emitting layer of R1 and the organic light emitting layer of R2. The cathode layers of R1 and R2 are not partitioned by the partition layer, in other words, R1 and R2 share a cathode layer. In other words, in this embodiment of this application, a partition layer is arranged, the partition layer divides an anode of the R subpixel into two anodes, and areas of the two anodes may be the same or may be different. The partition layer further divides an organic light emitting layer of the R subpixel into two parts, and areas of the two organic light emitting layers may be the same or different. In an optional case, it may further be said that the light emitting device of each sub-subpixel includes an anode layer, an organic light emitting layer, and a cathode layer.

For example, the anode layer includes a combination of one or more layers of materials, for example, a combination of indium tin oxide (indium tin oxide, ITO) + a silver Ag layer + an ITO layer, a combination of an ITO layer + an aluminum Al layer + an ITO layer, a combination of an Al layer and an ITO layer, and a combination of an Ag layer and an ITO layer. The anode layer is prepared in a process of physical vapor deposition, sputtering, electron beam evaporation, or the like. It should be understood that, FIG. 1 shows only several key layers, and the schematic diagram of the pixel structure shown in FIG. 1 does not constitute a limitation on the pixel structure. For example, the organic light emitting layer may include a plurality of layers, such as a hole injection layer, a hole transport layer, a light emitting layer, a hole barrier layer, an electron transport layer, and an electron injection layer. An organic light emitting material is arranged on the organic light emitting layer. For example, a red light emitting material is arranged on the organic light emitting layer of the R subpixel, a green light emitting material is arranged on the organic light emitting layer of the G subpixel, and a blue light emitting material is arranged on the organic light emitting layer of the B subpixel. When holes are injected from the anode layer and electrons are injected from the cathode layer, light emitting excitons are formed on the light emitting material, and the light emitting excitons release energy in a form of light, thereby realizing light emission. Specifically, the red light emitting material emits red light, the green light emitting material emits green light, and the blue light emitting material emits blue light. The cathode layer is usually made of a metal material such as silver-magnesium alloys, aluminum, or silver, and the cathode is usually prepared in a process of physical vapor deposition, electron beam evaporation, resistive thermal evaporation, or the like. In an optional case, the pixel structure further includes a circular polarizing filter arranged on the cathode layer of the light emitting device.

A pixel definition layer is arranged between two adjacent subpixels, and the pixel definition layer is configured to block pixel crosstalk between the adjacent subpixels. The partition layer is configured to block transverse current crosstalk or pixel crosstalk between adjacent subpixels, in other words, the partition layer is configured to block OLEDs of two subpixels, to prevent mutual interference of transverse currents of the two adjacent OLEDs. The pixel crosstalk means abnormal display caused by transverse current crosstalk between adjacent pixels. For example, when a red subpixel is driven to emit light, an adjacent blue subpixel and an adjacent green subpixel are also driven to light up due to transverse current crosstalk. A material of the partition layer is the same as a material of the pixel definition layer, and may be, for example, a photoresist, such as a Microchem SU-8 photoresist. Usually, an etching process of exposure development is used for the partition layer and the pixel definition layer, and the etching process follows a preparation process of the anode. It should be understood that, the three-dimensional view shown in FIG. 2 is a simplified three-dimensional view showing only the anode layer, the organic light emitting layer, and the cathode layer. The anode layer represents a plane on which the anode is located. A plurality of anodes on the plane are separated by the pixel definition layer or the partition layer. As shown in FIG. 2, a gray shaded part is the anode, two anodes inside the subpixel are separated by the partition layer, and anodes between adjacent subpixels are separated by the pixel definition layer. That is, a blank part in the anode layer other than the gray shaded part in FIG. 2 is the pixel definition layer or the partition layer, a blank part between the two anodes inside the subpixel is the partition layer, and a blank part of the anodes between two adjacent subpixels is the pixel definition layer.

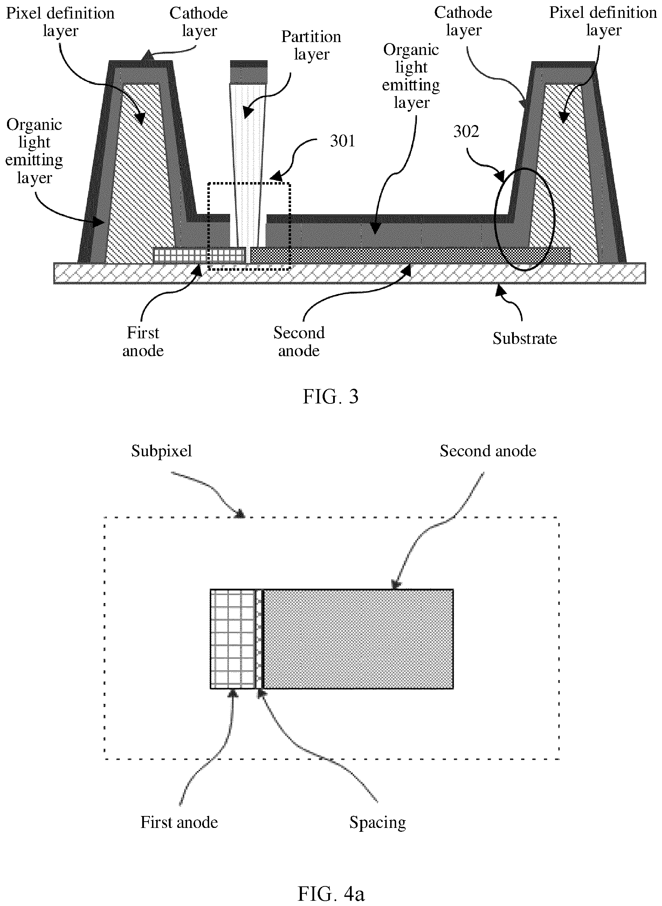

An included angle between a side surface of the partition layer and a first plane is less than or equal to 90 degrees, the first plane is parallel to a plane in which a surface of the pixel structure is located, and the first plane is further parallel to a substrate plane. An included angle between a side surface of the pixel definition layer and the first plane is greater than 90 degrees. FIG. 3 is a schematic cross-sectional view of a pixel structure according to this application. It can be learned from FIG. 3 that, an included angle between the side surface of the partition layer and the substrate plane is less than or equal to 90 degrees, in other words, a width of an upper surface of the partition layer is greater than a width of a lower surface. The upper surface is a plane away from the substrate, and the lower surface is a plane close to the substrate. During vapor deposition of an organic light-emitting material, a continuous thin film cannot be formed during vapor deposition of the organic light-emitting material due to shielding of the upper surface of the partition layer, as shown in a dashed-line region 301 in FIG. 3, that is, there is a spacing between the side surface of the partition layer and the organic light emitting layer. If the included angle between the side surface of the partition layer and the substrate plane is greater than 90 degrees, the continuous thin film structure is formed during vapor deposition of the organic light-emitting material. The organic light emitting layer includes a hole injection layer (not shown in FIG. 3), the hole injection layer is made of a material with a high conductivity, and a width of the partition layer is usually only 1 $\mu$m to 2 $\mu$m. If a continuous thin film structure is formed, there may be transverse current crosstalk in the hole injection layers on both sides of the partition layer. Therefore, in this embodiment of this application, the included angle between the side surface of the partition layer and the substrate plane is less than or equal to 90 degrees, and the continuous thin film cannot be formed during vapor deposition of the organic light-emitting material, so that a distance between the hole injection layers on both sides of the partition layer is increased, and transverse current crosstalk is avoided in the hole injection layers on both sides of the partition layer. Because the angle between the pixel definition layer and the substrate plane is greater than 90 degrees, the continuous thin film structure can be formed during vapor deposition of the organic light-emitting material, as shown in a region 302 in an ellipse in FIG. 3. A width of the pixel definition layer is usually 20 $\mu$m to 40 $\mu$m. Even if the continuous thin film structure is formed during vapor deposition of the organic light-emitting material, the hole injection layers on two adjacent sides of the pixel definition layer has a large resistance, and the formed transverse current crosstalk is very weak and may be basically ignored. In addition, continuity and integrity of the cathode are not destroyed, and conductivity of a whole surface of the cathode is ensured. It should be understood that, a drive layer is further arranged between the substrate layer and the anode layer, and the drive layer is not shown in FIG. 3.

The pixel structure further includes: a substrate layer. The substrate layer is, for example, a flexible substrate (Flexible Substrate) layer or a glass substrate layer.

The pixel structure further includes: a drive layer, arranged on an upper surface of the substrate layer. The drive layer is internally provided with a drive circuit configured to drive a light emitting device arranged on the drive layer. When the pixel is a pixel in an AMOLED display panel, the drive layer may also be referred to as a thin film transistor (Thin film transistor, TFT) layer. The TFT layer includes a plurality of switches, and an anode of each sub-subpixel corresponds to one switch. In addition, on or off of each sub-subpixel is independently controlled by respective corresponding switch. It should be understood that, the switch included in the TFT layer may include one or more switching transistors. A quantity of switching transistors included in the switch in the TFT layer is not limited in this embodiment of this application.

In an optional case, the drive circuit is arranged on the TFT layer, each subpixel corresponds to one drive circuit, the drive circuit includes one main switch and a plurality of branch switches, and a quantity of branch switches included in the drive circuit is equal to a quantity of sub-subpixels included in a subpixel corresponding to the drive circuit. In addition, the branch switches are in a one-to-one correspondence with the sub-subpixels, and each branch switch is configured to control light emitting of a corresponding subpixel. For example, the switch may be an N-type TFT or a P-type TFT. Specifically, each subpixel includes one light emitting diode. The light emitting diode is, for example, an OLED. The branch switch is connected in series to a light emitting diode in a sub-subpixel in a corresponding branch. The branch switch is configured to control on or off of the light emitting diode in the corresponding sub-subpixel. For example, the branch switch receives a control signal from a central processing unit (Central Processing Unit, CPU), a general-purpose processor, a dedicated processor, a controller, or a DDIC, and is turned on or off under an effect of the control signal, so that the light emitting diode of the branch on which the branch switch is located is turned on or off. When the light emitting diode is turned on, a drive current flows through the light emitting diode, and the sub-subpixel corresponding to the light emitting diode emits light. Therefore, the drive circuit provided in this application can separately and independently control the plurality of sub-subpixels to emit light. It should be understood that, one main switch or one branch switch may include one or more switching transistors. A quantity of switching transistors included in the main switch or the branch switch is not limited in this embodiment of this application.

Further, the plurality of branch switches are connected in parallel; after being connected in parallel, the plurality of branch switches are connected in series to the main switch; the main switch is connected to an input end of the drive circuit, the input end is configured to input a drive voltage; and the drive voltage is related to a display gray scale of a subpixel corresponding to the drive circuit. When the input end inputs the drive voltage, the main switch is turned on; and after flowing through the main switch, the drive current flows to one or more light emitting diodes through a conducted branch, to drive the one or more sub-subpixels to emit light.

In an example, each subpixel includes three sub-subpixels, the drive circuit corresponding to the subpixel includes one main switch and three branch switches. When a display gray scale is input to the subpixel, the main switch is turned on under an effect of the drive voltage. If states of the three branch switches under the actions of respective control signals are successively on, off, and on, after flowing through the main switch, the drive current flows through a first branch switch and drives a first sub-subpixel to emit light.

In a possible implementation, a first subpixel includes a plurality of sub-subpixels, the first subpixel is any subpixel in the pixel structure. When the display gray scale input into the first subpixel is less than a first threshold, only the first subpixel may be controlled to emit light, and the first sub-subpixel is a sub-subpixel with a smallest light emitting area in the plurality of sub-subpixels.

It should be understood that, in this embodiment of this application, light emitting areas of a plurality of sub-subpixels included in one subpixel are usually designed to be gradient. In other words, the light emitting areas of the plurality of sub-subpixels successively increase. When the display gray scale input to the subpixel is very low, only the sub-subpixel with a smallest light emitting area is controlled to be turned on and emit light, so that the current density of the light emitting diode can be effectively increased, the light emitting diode can have a stable light emitting spectrum when the input display gray scale is low, and the display color cast is reduced.

In a possible implementation, when the display gray scale input into the first subpixel is greater than a second threshold, all sub-subpixels in the first subpixel are controlled to emit light.

When the display gray scale of the subpixel is greater than the second threshold, the light emitting spectrum of the subpixel tends to be stable, and a displayed color is accurate and even. In this case, all sub-subpixels are controlled to emit light, to ensure that the current density of each sub-subpixel is within the rated range, thereby lighting the subpixel in a full area, and improving display efficiency of the subpixel.

In a possible implementation, a first subpixel includes a first sub-subpixel and a second sub-subpixel, the first subpixel is any subpixel in the plurality of subpixels, and a light emitting area of the first sub-subpixel is less than a light emitting area of the second sub-subpixel. When the display gray scale of the first subpixel is less than a first threshold, the first sub-subpixel is controlled to emit light.

In a possible implementation, when the display gray scale of the first subpixel is greater than or equal to the first threshold and is less than a second threshold, the second sub-subpixel is controlled to emit light. The second threshold is greater than the first threshold. When the display gray scale of the first subpixel is greater than or equal to the second threshold, both the first sub-subpixel and the second sub-subpixel are controlled to emit light.

In a case in which one subpixel includes two sub-subpixels, when the lighting area of the subpixel is controlled based on the display gray scale, the display gray scale is divided into three segments based on the following rule: less than the first threshold, between the first threshold and the second threshold, and greater than the second threshold. Correspondingly, there may be three solutions for controlling the light emitting area of the subpixel: lighting only a sub-subpixel with a smaller light emitting area, lighting only a sub-subpixel with a larger light emitting area, or lighting both sub-subpixels. When the display gray scale of the subpixel is lower than the first threshold, the current density corresponding to the subpixel is very small, the light emitting spectrum of the subpixel is unstable, and problems such as display color cast and uneven display occur. In this case, the first sub-subpixel with a smaller light emitting area in the plurality of sub-subpixels is controlled to be turned on and emit light. Because the light emitting area of the first sub-subpixel is small, a current density of the first sub-subpixel is multiplied, and the light emitting spectrum is more stable, so that display color cast can be effectively reduced. When the display gray scale of the subpixel is greater than or equal to the first threshold and is less than the second threshold, if a sub-subpixel with a smallest light emitting area is driven to emit light, a current density of the subpixel may exceed a rated current and the subpixel is burned. However, if the entire subpixel is lit (in other words, the subpixel is driven to emit light in a full area), the display spectrum may still unstable. In this case, the second sub-subpixel with a larger light emitting area may be lit, thereby increasing the current density of the light emitting diode, improving stability of the light emitting spectrum, reducing display color cast, and additionally, ensuring that the current density of the diode does not exceed the rated current, to avoid burning the diode. When the display gray scale of the subpixel is greater than the second threshold, the light emitting spectrum of the subpixel tends to be stable, and a displayed color is accurate and even. In this case, all sub-subpixels are controlled to emit light, to ensure that the current density of each sub-subpixel is within the rated range, thereby lighting the subpixel in a full area, and improving display efficiency of the subpixel.

In a possible implementation, the first subpixel is a G subpixel, the first threshold is 32, and the second threshold is 64.

It should be understood that, when the display gray scale of the subpixel is lower than the first threshold, the light emitting spectrum of the subpixel is unstable, and display color cast occurs. Different types of subpixels have different first thresholds corresponding to an occurrence of display color cast. For example, first thresholds corresponding to the occurrence of display color cast of the R subpixel, the G subpixel, and the B pixel are different. In addition, different types of display panels or a same type of display panels produced by different manufacturers may also have different first thresholds corresponding to the occurrence of display color cast. When the gray scale input into the subpixel is greater than the second threshold, the light emitting spectrum of the subpixel tends to be stable, and a displayed color is accurate and even. Different types of subpixels correspond to different second thresholds. For example, the R subpixel, the G subpixel the B pixel correspond to different second thresholds. In addition, different types of display panels or a same type of display panels produced by different manufacturers may also have different second thresholds.

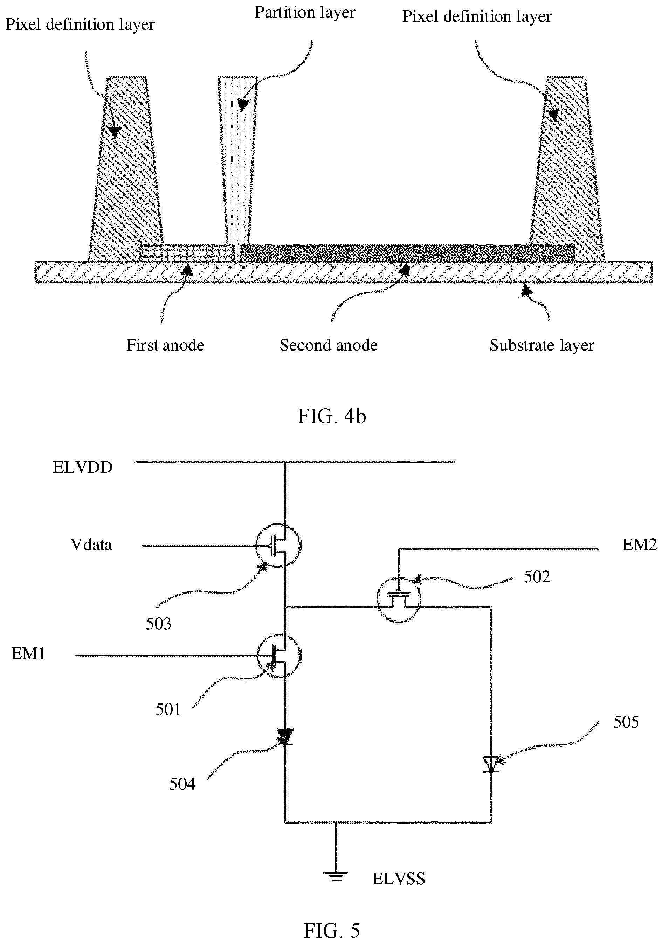

FIG. 4a is a schematic diagram of an anode layer of a pixel structure according to an embodiment of this application, FIG. 4b is a schematic cross-sectional view of a pixel structure according to an embodiment of this application, FIG. 5 is a schematic diagram of a principle of a drive circuit according to an embodiment of this application, and the drive circuit is a drive circuit corresponding to the pixel structures shown in FIG. 4a and FIG. 4b.

FIG. 4a shows only one subpixel, a dashed-line box represents one subpixel, and a first anode, a second anode, and a spacing between two anodes are shown in the dashed-line box. It should be understood that, a blank part in the dashed-line box other than the first anode, the second anode, and the spacing between the two anodes is a pixel definition layer. The subpixel includes two sub-subpixels: a first sub-subpixel and a second sub-subpixel. The subpixel includes the first anode and the second anode, the first anode is an anode of the first sub-subpixel, the second anode is an anode of the second sub-subpixel, there is spacing between the first anode and the second anode, and a partition layer is arranged in the spacing. For example, the spacing between the first anode and the second anode is 1 $\mu$m to 2 $\mu$m. It should be understood that, if the anode of the subpixel is divided into more anodes, a spacing between every two adjacent anodes is 1 $\mu$m to 2 $\mu$m. For example, in a preparation process of an OLED anode, the anode of the subpixel is divided into two anodes with a small area, a ratio of areas of the two anodes may be any integer or decimal from 1 to 10, and an area of the entire dashed-line box is an area of the subpixel. It can be learned from the foregoing definition that an aperture ratio of a pixel is a ratio of an area of the anode to an area of the pixel. When only one sub-subpixel is lit, an aperture ratio of a corresponding subpixel is about 1% to 20%. If the ratio of areas of the two anodes is excessively large, the area of the second anode is excessively small, and preparation difficulty is increased. If the ratio of areas of the two anodes is excessively small, display effect at a low gray scale is poor. When pattern processing is performed on the anode, a spacing with a width of 1-2 $\mu$m is etched in the anode of the subpixel, and a material such as a photoresist is subsequently filled in the spacing to form the partition layer, so that two independent anodes are formed. The two anodes are separately connected to a drive circuit in a drive layer by punching and leading wire. Specifically, the two anodes are separately connected to a switch in a drive layer by punching and leading wire. As shown in FIG. 4b, an included angle between a side surface of a partition layer and a substrate surface is less than 90 degrees. Therefore, as a height of the partition layer gradually increases, a cross section of the partition layer also gradually increases. Therefore, during vapor deposition of an organic light emitting layer on an anode layer, an area of the organic light emitting layer is smaller than an area of the anode. A light emitting area of the sub-subpixel depends on an overlapping area of the anode and the organic light emitting layer, so the light emitting area of the sub-subpixel is slightly smaller than the area of the anode. It should be understood that, when two adjacent sub-subpixels are lit, a non-light emitting part between the two sub-subpixels is a spacing between the two sub-subpixels, and the spacing between the two adjacent sub-subpixels is greater than a spacing between two anodes respectively corresponding to the two sub-subpixels. Pixel definition layers are respectively arranged on two sides of the subpixel, the pixel definition layer is configured to block adjacent subpixels, and an included angle between a side surface of the pixel definition layer and the substrate surface is greater than 90 degrees.

FIG. 5 is a schematic diagram of a principle of a drive circuit corresponding to the pixel structure shown in FIG. 4a. The drive circuit includes: a first branch switch 501, a second branch switch 502, a main switch 503, a first light emitting diode 504, and a second light emitting diode 505. The first light emitting diode 504 corresponds to a first sub-subpixel, and the second light emitting diode 505 corresponds to a second sub-subpixel. In this embodiment of this application, a light emitting area of the first light emitting diode 504 is smaller than a light emitting area of the second light emitting diode 505. The first branch switch 501 is connected in series to the first light emitting diode 504, the second branch switch 502 is connected in series to the second light emitting diode 505, the first branch switch 501 is configured to control on or off of the first light emitting diode 504, and the second branch switch 502 is configured to control on or off of the second light emitting diode 505.

It should be understood that, the first branch switch 501, the second branch switch 502, and the main switch 503 are arranged in the drive layer, and the first light emitting diode 504 and the second light emitting diode 505 are arranged in the anode layer, the organic light emitting layer, and the cathode layer. In other words, the first light emitting diode 504 and the second light emitting diode 505 each include an anode layer, an organic light emitting layer, and a cathode layer. The first light emitting diode 504 and the second light emitting diode 505 are respectively connected to the first branch switch 501 and the second branch switch 502 in the drive layer through punching and leading wire.

Specifically, the main switch 503, the first branch switch 501, and the second branch switch 502 each include a gate electrode, a source electrode, and a drain electrode. The gate electrode of the main switch is connected to a drive voltage Vdata, and the drive voltage Vdata corresponds to the display gray scale of the subpixel. The source electrode of the main switch is connected to a high voltage ELVDD. For example, the ELVDD is a voltage of an electroluminescent device, and the ELVDD may range from 3.0 V to 8.0 V The drain electrode of the main switch is connected to the source electrode of the first branch switch 501 and the source electrode of the second branch switch 502. The gate electrode of the first branch switch 501 is connected to a first control signal EM1, in other words, the gate electrode of the first branch switch 501 is configured to receive the first control signal EM1. The drain electrode of the first branch switch 501 is connected to a first end (an anode end) of the first light emitting diode 504, and a second end (a cathode end) of the first light emitting diode 504 is connected to a low voltage ELVSS. For example, the ELVSS is a common ground voltage of the electroluminescent device, and the ELVSS may range from -0.5 V to -5.0 V The gate electrode of the second branch switch 502 is connected to a second control signal EM2, in other words, the gate electrode of the second branch switch 502 is configured to receive the second control signal EM2. The drain electrode of the second branch switch 502 is connected to a first end (an anode end) of the second light emitting diode 505, and a second end (a cathode end) of the second light emitting diode 505 is connected to the low voltage ELVSS. The control signals EM1 and EM2 are transmitted by a CPU, a general-purpose processor, a dedicated processor, a controller, or a DDIC based on the display gray scale of the subpixel. For example, the control signals EM1 and EM2 may be signals for controlling the switches to be turned on, or may be signals for controlling the switches to be turned off. It should be understood that, the main switch 503, the first branch switch 501, and the second branch switch 502 in the drive circuit may be N-type TFTs or P-type TFTs.

In an optional case, the processor or the DDIC may detect the display gray scale input into the subpixel. When the display gray scale is lower than the first threshold, for example, the first threshold is 32, the processor or the DDIC sends the first control signal to the drive circuit in the pixel structure. The first control signal indicates to turn on the first branch switch 501 and turn off the second branch switch 502, so that only the first light emitting diode 504 with a smaller light emitting area is driven to emit light, a current density of the OLED is multiplied, stability of the light emitting spectrum is improved, and the display color cast is reduced. For example, the first control signal includes the EM1 and the EM2. The EM1 is for turning on the first branch switch 501, and the EM2 is for turning off the second branch switch 502. In an optional case, if the two branch switches are turned on by default, when determining that the display gray scale is lower than the first threshold, the processor or the DDIC sends the first control signal to the drive circuit to turn on or off the second branch switch 502. In an optional case, if the two branch switches are turned off by default, when determining that the display gray scale is lower than the first threshold, the processor or the DDIC sends the first control signal to the drive circuit to turn on the first branch switch 501.

When the processor or the DDIC determines that the display gray scale is greater than or equal to the first threshold and is less than the second threshold, for example, the second threshold is 64, the processor or the DDIC sends a second control signal to the drive circuit in the pixel structure. The second control signal indicates to turn off the first branch switch 501, and turn on the second branch switch 502, to drive only the second light emitting diode 505 with a larger light emitting area to emit light. In this way, the first light emitting diode 504 with a smaller light emitting area can be prevented from being burnt caused by a current density exceeding a rated current. In addition, the light emitting area of the second light emitting diode 505 is less than a light emitting area of the entire subpixel, so that a current density of the OLED can still be increased, the stability of the light emitting spectrum is improved, and the display color cast is reduced.

When the processor or the DDIC determines that the display gray scale is greater than or equal to the second threshold, the processor or the DDIC sends a third control signal to the drive circuit in the pixel structure. The third control signal indicates to turn on the first branch switch 501 and the second branch switch 502, to drive both the first light emitting diode 504 and the second light emitting diode 505 to emit light. In this way, the two light emitting diodes may share a large working current, to ensure that a current density of each sub-subpixel is within a rated range, thereby lighting the subpixel in a full area, and improving display efficiency of the subpixel.

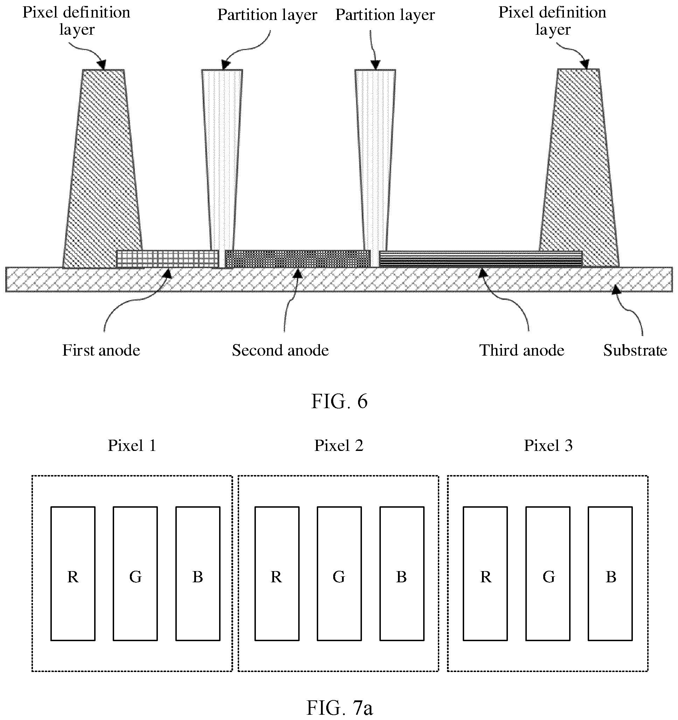

In this embodiment of this application, the subpixel may be further divided into more than two sub-subpixels, and light emitting areas of a plurality of sub-subpixels are gradient and successively increase. FIG. 6 is a schematic cross-sectional view of an example of a pixel structure according to an embodiment of this application. In the pixel structure, one subpixel includes three sub-subpixels, a partition layer is arranged between two adjacent sub-subpixels, and a pixel definition layer is arranged between two adjacent subpixels. An anode of the subpixel is divided into a first anode, a second anode, and a third anode, and areas of the first anode, the second anode, and the third anode successively increase. It should be understood that, FIG. 6 shows only a substrate layer and an anode layer, a drive layer is further arranged between the substrate layer and the anode layer, and at least an organic light emitting layer, a cathode layer, and the like are further arranged on the anode layer. A drive circuit of the pixel structure corresponding to FIG. 6 includes one main switch and three branch switches, each branch switch corresponds to one sub-subpixel, and each sub-subpixel is turned on or off under an effect of the corresponding branch switch.

When the display gray scale of the first subpixel is less than a first threshold, a first sub-subpixel is controlled to emit light. When the display gray scale of the first subpixel is greater than or equal to the first threshold and is less than a second threshold, a second sub-subpixel is controlled to emit light. When the display gray scale of the first subpixel is greater than or equal to the second threshold and is less than a third threshold, a third sub-subpixel is controlled to emit light. When the display gray scale of the first subpixel is greater than or equal to the third threshold, all three sub-subpixels are controlled to emit light.

In an optional case, based on the display gray scale, only the first sub-subpixel and the second sub-subpixel may be controlled to emit light, or only the second sub-subpixel and the third sub-subpixel may be controlled to emit light.

It should be understood that, when the subpixel includes more sub-subpixels, and the lighting area of the subpixel is controlled based on the display gray scale, the display gray scale may be divided into more segments. Correspondingly, there are more solutions for controlling the light emitting area of the subpixel. More detailed division levels of the display gray scale, more flexible and smooth control on display effect.

The pixel structures shown in FIG. 1 to FIG. 6 are used in a self-luminous display panel. An embodiment of this application further provides a self-luminous display panel. The self-luminous display panel includes the pixel structure provided in embodiments of this application. In an optional case, all pixels included in the self-luminous display panel are the pixel structure provided in embodiments of this application, or some pixels in the self-luminous display panel are the pixel structure provided in embodiments of this application.

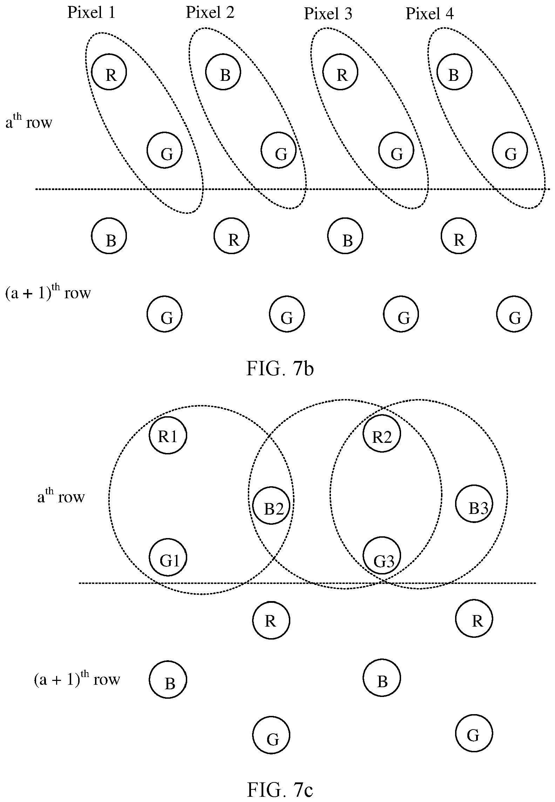

For example, the self-luminous display panel may include: a Micro LED display panel, an OLED display panel, an AMOLED display panel, or a PMOLED display panel. The display panel may be used to produce a display screen of an intelligent terminal such as a mobile phone, a smart large screen, a television, a personal computer, a tablet computer, a smart refrigerator, and an intelligent wearable device. The plurality of subpixels included in the pixel structure include an R subpixel, a G subpixel, and a B subpixel, and the plurality of subpixels may be distributed in RGB distribution, RGBG distribution, or RGB delta distribution. FIG. 7a is an example of a display panel in RGB distribution according to an embodiment of this application. Each pixel includes three subpixels: a red subpixel R, a green subpixel G, and a blue subpixel B. FIG. 7b is an example of a display panel in RGBG distribution according to an embodiment of this application. Each pixel includes two subpixels. In FIG. 7b, a pixel 1 in an $a^{th}$ row includes two subpixels R and G, and a pixel 2 includes two subpixels B and G, a pixel 3 includes two subpixels R and G, and a pixel 4 includes two subpixels B and G, which alternately appear in a combination of R and G and a combination of B and G. FIG. 7c is an example of a display panel in RGB delta distribution according to an embodiment of this application. Each pixel includes three subpixels: R, G, and B, and two adjacent pixels have a shared subpixel. For example, in an a<sup>th</sup> row in FIG. 7c, a pixel 1 and a pixel 2 share a blue subpixel B2, and the pixel 2 and a pixel 3 share a red subpixel R2 and a green subpixel G3.

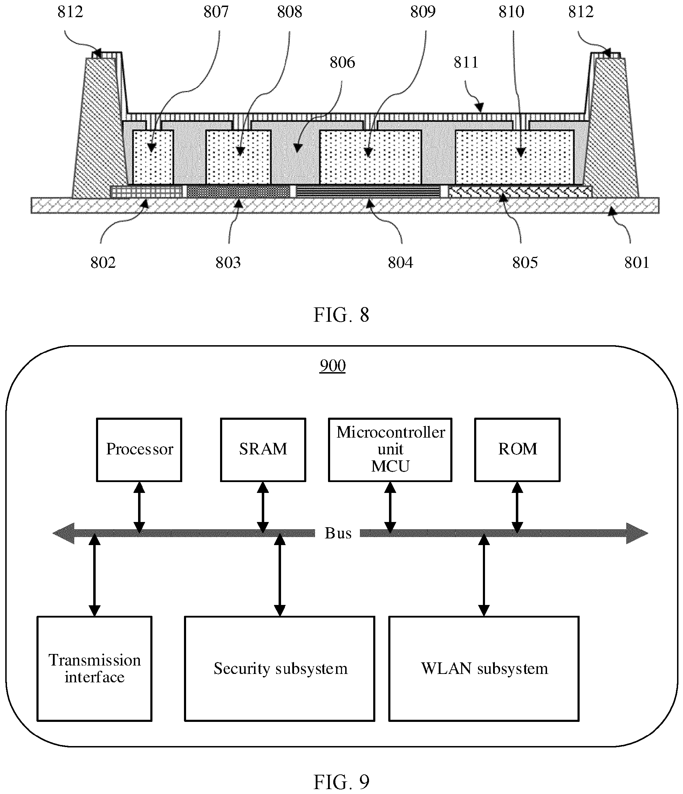

FIG. 8 is a schematic cross-sectional view of a pixel structure according to an embodiment of this application. The pixel structure is used in the micro LED display panel, a plurality of micro LEDs of different sizes are arranged in a single subpixel, and a light emitting area of the subpixel is controlled based on a display gray scale input into the subpixel, thereby ensuring that a current density of the subpixel is increased, and also ensuring that a current density of each micro LED does not exceed a rated current density. The pixel structure includes: a substrate layer 801, a plurality of anodes 802 to 805 arranged on the substrate layer 801, and a coplanar cathode 811. The substrate layer may be, for example, a flexible substrate, a glass substrate, or a silicon-based backplane.

The plurality of anodes have different light emitting areas, a planarization layer 806 is arranged between two adjacent light emitting areas, the planarization layer 806 may be made of an organic polymer, and the organic polymer may include: a photoresist material and an inorganic material such as silicon nitride and silicon oxide.

A plurality of micro LEDs 807 to 810 are arranged on an anode layer, and the plurality of micro LEDs 807 to 810 have different sizes, in other words, have different light emitting areas. The micro LED is prepared in a traditional process of growing III-V semiconductor. A planarization layer 806 is arranged between two adjacent micro LEDs.

The plurality of micro LEDs 807 to 810 share the coplanar cathode 811.

The pixel structure further includes: a pixel definition layer 812, limiting a size of the subpixel and preventing optical crosstalk between adjacent subpixels. It should be understood that, only one subpixel is shown in FIG. 8. The subpixel includes a plurality of sub-subpixels, and each sub-subpixel corresponds to one micro LED.

In an optional case, cathodes 802 to 805 close to the substrate layer 801 are a plurality of cathodes with different areas, and the cathode 811 away from the substrate layer 801 is a coplanar anode.

FIG. 9 shows a display control apparatus 900 according to an embodiment of this application. The display control apparatus is configured to control a pixel structure in a self-luminous display panel. The pixel structure includes a plurality of sub-subpixels, and each of the plurality of subpixels includes a plurality of sub-subpixels, for example, any pixel structure provided in FIG. 1 to FIG. 6 and FIG. 8 in embodiments of this application. The display control apparatus 900 includes a processor and a transmission interface. The display control apparatus may be a processor chip in a whole machine, or may be a whole machine including a processor chip. For example, the processor may include a general-purpose central processing unit (Central Processing Unit, CPU) and a dedicated processing device integrated in a system on chip (System on Chip, SOC), for example, an application-specific integrated circuit (Application-Specific Integrated Circuit, ASIC), a field programmable gate array (Field Programmable Gate Array, FPGA) or a digital signal processor (Digital Signal Processor, DSP), a dedicated video or graphics processor, a graphics processing unit (Graphics Processing Unit, GPU), an application processor (Application Processor, AP), a neural-network processing unit (Neural-network Processing Unit, NPU), and the like. Alternatively, the processor may be a DDIC. The CPU may be, for example, a single-core CPU or a multi-core CPU. Optionally, the CPU may be a processor group including a plurality of processors, and the plurality of processors are coupled to each other through one or more buses.

The transmission interface may be an interface that is of the processor chip and that is for receiving and sending data. The transmission interface usually includes a plurality of interfaces. In an optional case, the transmission interface may include an inter-integrated circuit (Inter-Integrated Circuit, I2C) interface, a serial peripheral interface (Serial Peripheral Interface, SPI), a universal asynchronous receiver-transmitter (Universal asynchronous receiver-transmitter, UART) interface, a general-purpose input/output (General-purpose input/output, GPIO) interface, and the like. It should be understood that these interfaces may implement different functions through reusing a same physical interface. In an optional case, the transmission interface may further include a high definition multimedia interface (High Definition Multimedia Interface, HDMI), a V-By-One interface, an embedded display port (Embedded Display Port, eDP), and a mobile industry processor interface (Mobile Industry Processor Interface, MIPI), a Display Port (DP), or the like.

The processor is configured to:

generate at least one control signal; and control the transmission interface to send at least one control signal to a first subpixel, where the first subpixel is any subpixel in the plurality of subpixels.

The at least one control signal indicates to control one or more sub-subpixels in a plurality of sub-subpixels included in the first subpixel to emit light.

In a possible implementation, the processor is further configured to determine whether a display gray scale of the first subpixel is less than a first threshold. When the processor determines that the display gray scale of the first subpixel is less than the first threshold, the processor is specifically configured to: generate a first control signal, where the at least one control signal includes the first control signal. The processor is further configured to control the transmission interface to send the first control signal to the first subpixel, the first control signal indicates to control a first sub-subpixel to emit light, and the first sub-subpixel is a sub-subpixel with a smallest light emitting area in the plurality of sub-subpixels included in the first subpixel.

In a possible implementation, the first subpixel includes a first sub-subpixel and a second sub-subpixel, a light emitting area of the second sub-subpixel is greater than the light emitting area of the first sub-subpixel. When determining that the display gray scale of the first subpixel is greater than or equal to the first threshold and is less than the second threshold, the processor is specifically configured to: generate a second control signal, where the at least one control signal includes the second control signal. The processor is further configured to control the transmission interface to send the second control signal to the first subpixel, and the second control signal indicates to control the second sub-subpixel to emit light. The second threshold is greater than the first threshold.

In a possible implementation, when determining that the display gray scale of the first subpixel is greater than or equal to the second threshold, the processor is specifically configured to: generate a third control signal, where the at least one control signal includes the third control signal. The processor is further configured to control the transmission interface to send the third control signal to the first subpixel, and the third control signal indicates to control all the plurality of sub-subpixels to emit light.

In a possible implementation, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

In a possible implementation, the processor is configured to:
determine whether the display gray scale of the first subpixel is less than the first threshold, where the first subpixel is any subpixel in the plurality of subpixels of the pixel structure.

It should be understood that, the processor may detect a display gray scale input into each subpixel of the display panel, and when detecting that the display gray scale is lower than the first threshold, the processor determines that a current display gray scale of the subpixel is low, and there may be display color cast.

When the processor determines that the display gray scale of the first subpixel is less than the first threshold, the processor is further configured to control the transmission interface to send the first control signal to the first subpixel, where the first control signal indicates to control a first sub-subpixel to emit light, and the first sub-subpixel is a sub-subpixel with a smallest light emitting area in the plurality of sub-subpixels included in the first subpixel.

When the first subpixel includes two sub-subpixels, the first sub-subpixel and the second sub-subpixel, and a light emitting area of the second sub-subpixel is greater than the light emitting area of the first sub-subpixel, the processor is further configured to:
when determining that the display gray scale of the first subpixel is greater than or equal to the first threshold and is less than a second threshold, control the transmission interface to send a second control signal to the first subpixel, where the second control signal indicates to control the second sub-subpixel to emit light. The second threshold is greater than the first threshold.

When the processor determines that the display gray scale of the first subpixel is greater than or equal to the second threshold, the processor is further configured to control the transmission interface to send a third control signal to the first subpixel, where the third control signal indicates to control all the plurality of sub-subpixels to emit light.

It should be understood that, in this embodiment of this application, light emitting areas of a plurality of sub-subpixels included in one subpixel are usually designed to be gradient. In other words, the light emitting areas of the plurality of sub-subpixels successively increase. When the display gray scale input to the subpixel is very low, only the sub-subpixel with a smallest light emitting area is controlled to be turned on and emit light, so that the current density of the light emitting diode can be effectively increased, the light emitting diode can have a stable light emitting spectrum when the input display gray scale is low, and the display color cast is reduced. When the display gray scale of the subpixel is greater than or equal to the first threshold and is less than the second threshold, if a sub-subpixel with a smallest light emitting area is driven to emit light, a current density of the subpixel may exceed a rated current and the subpixel is burned. However, if the entire subpixel is lit (in other words, the subpixel is driven to emit light in a full area), the display spectrum may still unstable. In this case, the second sub-subpixel with a larger light emitting area may be lit, thereby increasing the current density of the light emitting diode, improving stability of the light emitting spectrum, reducing display color cast, and additionally, ensuring that the current density of the diode does not exceed the rated current, to avoid burning the diode. When the display gray scale of the subpixel is greater than the second threshold, the light emitting spectrum of the subpixel tends to be stable, and a displayed color is accurate and even. In this case, all sub-subpixels are controlled to emit light, to ensure that the current density of each sub-subpixel is within the rated range, thereby lighting the subpixel in a full area, and improving display efficiency of the subpixel.

In a possible implementation, the first control signal indicates to turn off a switch corresponding to another sub-subpixel other than the first sub-subpixel, and the second control signal is for turning off a switch corresponding to another sub-subpixel other than the second sub-subpixel.

It should be understood that, when switches corresponding to the plurality of sub-subpixels are turned on by default, and the processor detects that the display gray scale input into the subpixel is lower than the first threshold, a control signal is sent to turn off another sub-subpixel other than the sub-subpixel with a smallest light emitting area. When the processor determines that the display gray scale is greater than the second threshold, no control signal is sent, and the switches corresponding to the plurality of sub-subpixels are all turned on.

In a possible implementation, when the switches corresponding to the plurality of sub-subpixels are turned off by default, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

The display control apparatus 900 further includes: a memory, a microcontroller unit (Microcontroller Unit, MCU), a security subsystem, a WLAN subsystem, a bus, and the like. Although not shown in FIG. 9, the display control apparatus 900 may further include a power management subsystem, a clock management subsystem, a power consumption management subsystem, or other subsystem.

The foregoing parts of the display control apparatus 900 are coupled through a connector. For example, the connector includes various types of interfaces, transmission lines, buses, or the like. These interfaces are usually electrical communication interfaces, but may alternatively be mechanical interfaces or interfaces in other forms. This is not limited in this embodiment.

For example, a type of the memory may include, for example, a static random-access memory (Static random-access memory, SRAM) and a read-only memory (Read-Only Memory, ROM), and the memory may further include a volatile memory (volatile memory), such as a random access memory (Random Access Memory, RAM).

In an optional case, the foregoing parts are integrated on a same chip. In another optional case, the memory may be an independent chip.

The security subsystem may be configured to implement an encryption/decryption algorithm related to security authentication. It should be understood that the encryption/decryption algorithm related to security authentication is usually implemented by hardware, so that security of the encryption algorithm can be further improved.

For example, the WLAN subsystem may include a radio frequency (Radio Frequency, RF) circuit and a baseband.

A chip in this embodiment of this application is a system manufactured on a same semiconductor substrate in an integrated circuit process, and is also referred to as a semiconductor chip. The semiconductor chip may be a set of integrated circuits formed by manufacturing on a substrate (which is usually, for example, a semiconductor material of silicon) in the integrated circuit process. An external layer of the semiconductor chip is usually encapsulated by a semiconductor encapsulation material. The integrated circuit may include various types of functional devices. Each type of functional device includes a logic gate circuit, a metal-oxide-semiconductor (Metal-Oxide-Semiconductor, MOS) transistor, or a transistor such as a bipolar transistor or a diode, or may include another component such as a capacitor, a resistor, or an inductor. Each functional device may operate independently or operate under an action of necessary drive software, and may implement various functions such as communication, operation, or storage.

It should be understood that the processor is configured to invoke program code stored in the memory, to implement the foregoing corresponding functions. A high memory may be a memory on the processor chip, or may be a memory outside the processor chip. A form of an off-chip memory may include: a non-volatile memory, for example, an EMMC (Embedded MultiMedia Card, embedded multimedia card), a UFS (Universal Flash Storage, universal flash storage), an electrically erasable programmable read-only memory (Electrically Erasable Programmable Read-Only Memory, EEPROM), a compact disk read-only memory (Compact Disk Read-Only Memory, CD-ROM) or another optical disk memory, optical disc memory (including a compact disc, a laser disc, a digital universal disc, a blue-ray disc, and the like), a disk storage medium, or another magnetic storage device.

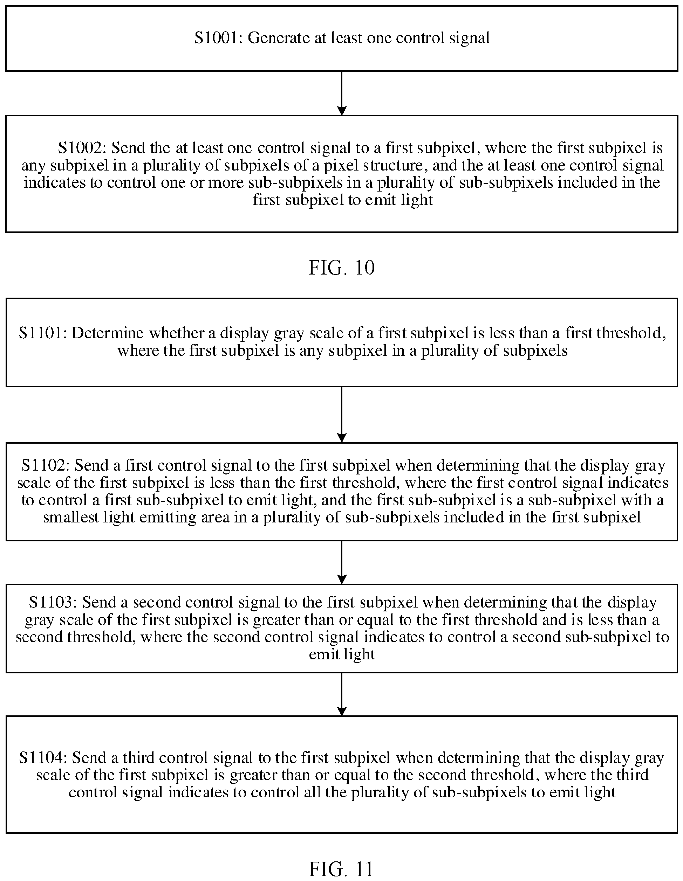

FIG. 10 shows a display control method according to an embodiment of this application. The method is used to control a pixel structure in a self-luminous display panel. The pixel structure includes a plurality of subpixels, and each of the plurality of subpixels includes a plurality of sub-subpixels, for example, any pixel structure provided in FIG. 1 to FIG. 6 and FIG. 8 in embodiments of this application. The method includes the following steps:

S1001: Generate at least one control signal.
S1002: Send the at least one control signal to a first subpixel, where the first subpixel is any subpixel in the plurality of subpixels of the pixel structure.

The at least one control signal indicates to control one or more sub-subpixels in a plurality of sub-subpixels included in the first subpixel to emit light.

In a possible implementation, the method further includes: determining whether a display gray scale of the first subpixel is less than a first threshold; generating a first control signal when determining that the display gray scale of the first subpixel is less than the first threshold, where the at least one control signal includes the first control signal; and sending the first control signal to the first subpixel, where the first control signal indicates to control a first sub-subpixel to emit light, and the first sub-subpixel is a sub-subpixel with a smallest light emitting area in the plurality of sub-subpixels included in the first subpixel.

In a possible implementation, the first subpixel includes the first sub-subpixel and a second sub-subpixel, a light emitting area of the second sub-subpixel is greater than the light emitting area of the first sub-subpixel. The method further includes: generating a second control signal when determining that the display gray scale of the first subpixel is greater than or equal to the first threshold and less than a second threshold, where the at least one control signal includes the second control signal; and sending the second control signal to the first subpixel, where the second control signal indicates to control the second sub-subpixel to emit light. The second threshold is greater than the first threshold.

In a possible implementation, the first control signal indicates to turn off a switch corresponding to another sub-subpixel other than the first sub-subpixel, and the second control signal is for turning off a switch corresponding to another sub-subpixel other than the second sub-subpixel.

In a possible implementation, the method further includes: generating a third control signal when determining that the display gray scale of the first subpixel is greater than or equal to the second threshold, where the at least one control signal includes the third control signal; and sending the third control signal to the first subpixel, where the third control signal indicates to control all the plurality of sub-subpixels to emit light.

In a possible implementation, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

FIG. 11 shows a display control method according to an embodiment of this application. The method is used to control a pixel structure in a self-luminous display panel. The pixel structure includes a plurality of subpixels, and each of the plurality of subpixels includes a plurality of sub-subpixels, for example, any pixel structure provided in FIG. 1 to FIG. 6 and FIG. 8 in embodiments of this application. The method includes the following steps:

S1101: Determine whether a display gray scale of a first subpixel is less than a first threshold, where the first subpixel is any subpixel in the plurality of subpixels.

S1102: Send the first control signal to the first subpixel when determining that the display gray scale of the first subpixel is less than the first threshold, where the first control signal indicates to control a first sub-subpixel to emit light, and the first sub-subpixel is a sub-subpixel with a smallest light emitting area in the plurality of sub-subpixels included in the first subpixel.

Optionally, the method further includes:
S1103: Send a second control signal to the first subpixel when determining that the display gray scale of the first subpixel is greater than or equal to the first threshold and is less than a second threshold, where the second control signal indicates to control the second sub-subpixel to emit light.

The first subpixel includes the first sub-subpixel and a second sub-subpixel, a light emitting area of the second sub-subpixel is greater than the light emitting area of the first sub-subpixel, and the second threshold is greater than the first threshold.

S1104: Send a third control signal to the first subpixel when determining that the display gray scale of the first subpixel is greater than or equal to the second threshold, where the third control signal indicates to control all the plurality of sub-subpixels to emit light.

It should be understood that, in this embodiment of this application, light emitting areas of a plurality of sub-subpixels included in one subpixel are usually designed to be gradient. In other words, the light emitting areas of the plurality of sub-subpixels successively increase. When the display gray scale input to the subpixel is very low, only the sub-subpixel with a smallest light emitting area is controlled to be turned on and emit light, so that the current density of the light emitting diode can be effectively increased, the light emitting diode can have a stable light emitting spectrum when the input display gray scale is low, and the display color cast is reduced. When the display gray scale of the subpixel is greater than or equal to the first threshold and is less than the second threshold, if a sub-subpixel with a smallest light emitting area is driven to emit light, a current density of the subpixel may exceed a rated current and the subpixel is burned. However, if the entire subpixel is lit (in other words, the subpixel is driven to emit light in a full area), the display spectrum may still unstable. In this case, the second sub-subpixel with a larger light emitting area may be lit, thereby increasing the current density of the light emitting diode, improving stability of the light emitting spectrum, reducing display color cast, and additionally, ensuring that the current density of the diode does not exceed the rated current, to avoid burning the diode. When the display gray scale of the subpixel is greater than the second threshold, the light emitting spectrum of the subpixel tends to be stable, and a displayed color is accurate and even. In this case, all sub-subpixels are controlled to emit light, to ensure that the current density of each sub-subpixel is within the rated range, thereby lighting the subpixel in a full area, and improving display efficiency of the subpixel.

In a possible implementation, the first control signal includes an enable signal for turning on a switch corresponding to the first sub-subpixel, and the second control signal includes an enable signal for turning on a switch corresponding to the second sub-subpixel, and the third control signal includes a plurality of enable signals for turning on switches corresponding to the plurality of sub-subpixels, where the plurality of enable signals are in a one-to-one correspondence with the plurality of sub-subpixels.

In a possible implementation, the first control signal indicates to turn off a switch corresponding to another sub-subpixel other than the first sub-subpixel, and the second control signal is for turning off a switch corresponding to another sub-subpixel other than the second sub-subpixel.

It should be understood that reference numbers of S1101 to S1104 do not limit an execution sequence of the method. Steps S1101 to S1104 may be usually performed synchronously or in a sequence, or the steps may not be strictly performed synchronously but there is a time difference between the steps. This is not limited in this embodiment of this application.

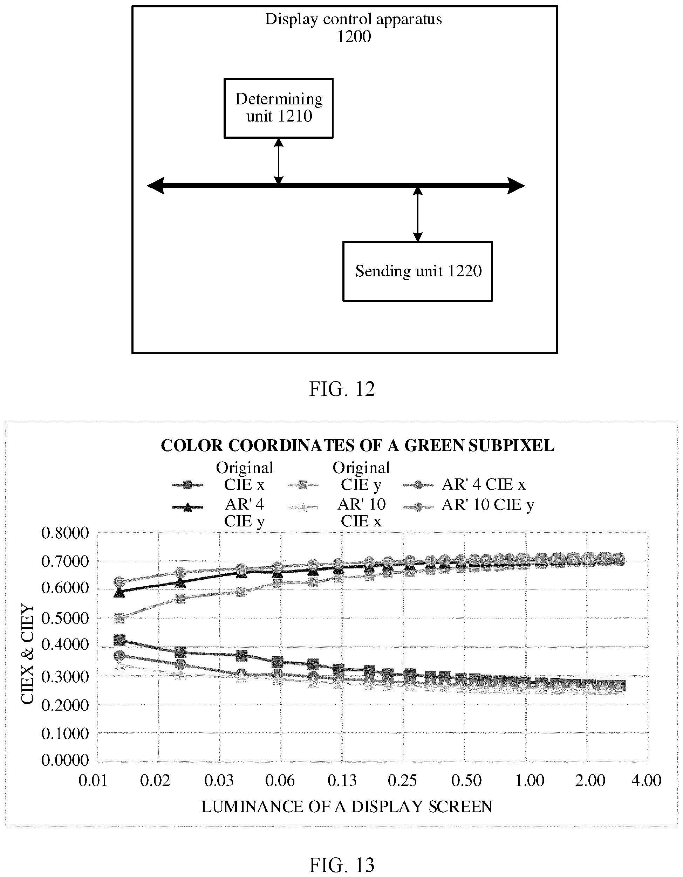

FIG. 12 is a schematic diagram of a structure of a display control apparatus 1200 according to an embodiment of this application. It should be understood that functions implemented by the processor and the transmission interface in FIG. 9 may be implemented by functional units run on the display control apparatus shown in FIG. 12. The functional units may be implemented by hardware, software, or implemented by software and hardware collaboratively. The display control apparatus 1200 includes: a determining unit 1210 and a sending unit 1220. The determining unit 1210 is configured to implement related functions of the processor in FIG. 9, and the sending unit 1220 is configured to implement related functions of the transmission interface in FIG. 9.

A person skilled in the art may understand that, in this embodiment of this application, division of the foregoing functional modules is merely used as an example for description. The division of the units is merely logical function division, and there may be another division manner in an actual implementation. A Unit described as a separate part may or may not be physically separate, and a part displayed as a unit may be one or more physical units. In addition, a plurality of units may be combined or integrated into another apparatus. In practical application, an inner structure of a device may be divided into different function modules according to a requirement, to implement all or some of the functions described above.

FIG. 13 is a simulation diagram of color coordinates of a green subpixel at a low display gray scale according to an embodiment of this application. It should be understood that, in this embodiment of this application, a CIE color coordinate change is used to indicate an OLED spectrum drift, a G subpixel is used as an example for simulation. A horizontal coordinate indicates a display luminance of a display panel in a unit of nit, and the display luminance is in a one-to-one correspondence with a display gray scale. A vertical coordinate indicates CIE color coordinates of the G subpixel, and the CIE color coordinates include a CIEx coordinate and a CIEy coordinate. Usually, when CIEx is less than 0.264 and CIEy coordinate are greater than 0.7, it indicates that a color of green light is stable and acceptable, otherwise, it indicates that color cast exists in the green light.

In a pixel structure corresponding to the simulation diagram shown in FIG. 13, a subpixel is divided into two sub-subpixels. When a ratio of light emitting areas of the two sub-subpixels is 1: 4, a stimulation result is denoted as AR' 4. When the ratio of light emitting areas of two sub-subpixels is 1: 10, a stimulation result is denoted as AR' 10. It can be seen from the figure that, for a conventional pixel structure, only when a display luminance of the display panel is greater than 3 nits, and a corresponding display gray scale is greater than 32, acceptable green light can be obtained. When the ratio of light emitting areas of two sub-subpixels is 1: 4, a display luminance is greater than 0.83 nits, and a corresponding display gray scale is 18, acceptable green light can be obtained. When the ratio of light emitting areas of two sub-subpixels is 1: 10, a display luminance is greater than 0.21 nits, and a corresponding display gray scale is 12, acceptable green light can be obtained. Therefore, it can be learned that, the pixel structure provided in embodiments of this application can effectively alleviate a problem of display color cast at a low display gray scale.

An embodiment of this application further provides a computer-readable storage medium. The computer-readable storage medium stores instructions. When the instructions are run on a computer or a processor, the computer or the processor is enabled to perform some or all steps in the display control method embodiment provided in embodiments of this application.

An embodiment of this application further provides a computer program product including instructions. When the computer program product is run on a computer or a processor, the computer or the processor is enabled to perform some or all steps in the display control method embodiment provided in embodiments of this application.

The foregoing embodiments are merely used for describing the technical solutions of this application, but are not intended to limit this application. Although this application is described in detail with reference to the foregoing embodiments, it should be appreciated by a person skilled in the art that, modifications may still be made to the technical solutions described in the foregoing embodiments, or equivalent replacements may be made to the part of the technical features; and such modifications or replacements will not cause the essence of corresponding technical solutions to depart from the scope of the technical solutions in embodiments of this application.

**Claims**

1. A pixel structure, wherein the pixel structure is used in a self-luminous display panel, and the pixel structure comprises: a plurality of subpixels, wherein at least one subpixel in the plurality of subpixels comprises a plurality of sub-subpixels, and a partition layer is arranged between two adjacent sub-subpixels in the at least one subpixel; and light emission of the plurality of sub-subpixels is separately and independently controlled.

2. The pixel structure according to claim 1, wherein a first subpixel comprises a first sub-subpixel and a second sub-subpixel, the first subpixel is any subpixel in the plurality of subpixels, and a light emitting area of the first sub-subpixel is less than a light emitting area of the second sub-subpixel; and the first sub-subpixel emits light, or the second sub-subpixel emits light, or both the first sub-subpixel and the second sub-subpixel emit light.

3. The pixel structure according to claim 2, wherein

   when a display gray scale of the first subpixel is less than a first threshold, the first sub-subpixel emits light;
   when the display gray scale of the first subpixel is greater than or equal to the first threshold and is less than a second threshold, the second sub-subpixel emits light, wherein the second threshold is greater than the first threshold; and
   when the display gray scale of the first subpixel is greater than or equal to the second threshold, both the first sub-subpixel and the second sub-subpixel emit light.

4. The pixel structure according to any one of claims 1 to 3, wherein an included angle between a side surface of the partition layer and a first plane is less than or equal to 90 degrees, and the first plane is parallel to a plane in which a surface of the pixel structure is located.

5. The pixel structure according to any one of claims 1 to 4, wherein each sub-subpixel in the plurality of sub-subpixels comprises an anode layer, an organic light emitting layer, and a cathode layer, and the organic light emitting layer is located between the anode layer and the cathode layer;

   the partition layer is arranged between anode layers of two adjacent sub-subpixels;
   the partition layer is arranged between organic light emitting layers of two adjacent sub-subpixels; and
the plurality of sub-subpixels share the same cathode layer.

6. The pixel structure according to any one of claims 1 to 5, wherein the pixel structure further comprises: a drive layer, wherein a drive circuit is arranged on the drive layer, each subpixel in the plurality of subpixels corresponds to one drive circuit, and the drive circuit is configured to separately and independently control the plurality of sub-subpixels to emit light;

   the drive circuit comprises a plurality of branch switches, a quantity of the plurality of branch switches is equal to a quantity of sub-subpixels comprised in one subpixel, and one branch switch corresponds to one sub-subpixel; and each sub-subpixel in the plurality of sub-subpixels comprises a light emitting diode, and the branch switch is configured to control on or off of a light emitting diode in a corresponding sub-subpixel.

7. The pixel structure according to claim 6, wherein the branch switch is connected in series to a branch of a corresponding light emitting diode; and the branch switch is specifically configured to receive a control signal, and be turned on or off under an effect of the control signal, so that the light emitting diode of the branch in which the branch switch is located is turned on or off.

8. The pixel structure according to claim 6 or 7, wherein the plurality of branch switches are connected in parallel; the drive circuit further comprises a main switch; after being connected in parallel, the plurality of branch switches are connected in series to the main switch; the main switch is connected to an input end of the drive circuit; when a drive voltage is input to the input end, the main switch is turned on; and the drive voltage corresponds to a display gray scale of a subpixel corresponding to the drive circuit.

9. A self-luminous display panel, wherein the self-luminous display panel comprises the pixel structure according to any one of claims 1 to 8.

10. A display control apparatus, wherein the display control apparatus is configured to control a pixel structure in a self-luminous display panel, the pixel structure comprises a plurality of subpixels, each subpixel in the plurality of subpixels comprises a plurality of sub-subpixels, and the display control apparatus comprises: a processor and a transmission interface, wherein

    the processor is configured to generate at least one control signal;

the processor is further configured to control the transmission interface to send the at least one control signal to a first subpixel, wherein the first subpixel is any subpixel in the plurality of subpixels; and
the at least one control signal indicates to control one or more sub-subpixels in a plurality of sub-subpixels comprised in the first subpixel to emit light.

11. The display control apparatus according to claim 10, wherein the processor is further configured to determine whether a display gray scale of the first subpixel is less than a first threshold;

when the processor determines that the display gray scale of the first subpixel is less than the first threshold, the processor is specifically configured to: generate a first control signal, wherein the at least one control signal comprises the first control signal; and
the processor is further configured to control the transmission interface to send the first control signal to the first subpixel, the first control signal indicates to control a first sub-subpixel to emit light, and the first sub-subpixel is a sub-subpixel with a smallest light emitting area in the plurality of sub-subpixels comprised in the first subpixel.

12. The display control apparatus according to claim 11, wherein the first subpixel comprises the first sub-subpixel and a second sub-subpixel, and a light emitting area of the second sub-subpixel is greater than the light emitting area of the first sub-subpixel;
when determining that the display gray scale of the first subpixel is greater than or equal to the first threshold and is less than a second threshold, the processor is specifically configured to:

generate a second control signal, wherein the at least one control signal comprises the second control signal;
the processor is further configured to control the transmission interface to send the second control signal to the first subpixel, and the second control signal indicates to control the second sub-subpixel to emit light; and
the second threshold is greater than the first threshold.

13. The display control apparatus according to claim 12, wherein the first control signal indicates to turn off a switch corresponding to another sub-subpixel other than the first sub-subpixel, and the second control signal is for turning off a switch corresponding to another sub-subpixel other than the second sub-subpixel.

14. The display control apparatus according to claim 12, wherein

when determining that the display gray scale of the first subpixel is greater than or equal to the second threshold, the processor is specifically configured to: generate a third control signal, wherein the at least one control signal comprises the third control signal; and
the processor is further configured to control the transmission interface to send the third control signal to the first subpixel, and the third control signal indicates to control all the plurality of sub-subpixels to emit light.

15. The display control apparatus according to claim 14, wherein the first control signal comprises an enable signal for turning on a switch corresponding to the first sub-subpixel, the second control signal comprises an enable signal for turning on a switch corresponding to the second sub-subpixel, and the third control signal comprises a plurality of enable signals for turning on switches corresponding to the plurality of sub-subpixels, wherein the plurality of enable signals are in a one-to-one correspondence with the plurality of sub-subpixels.

16. The display control apparatus according to any one of claims 10 to 15, wherein the self-luminous display panel comprises an organic light emitting diode OLED display panel, an active matrix organic light emitting diode AMOLED display panel, or a micro light emitting diode micro LED display panel.

17. A display control method, wherein the method is used to control a pixel structure in a self-luminous display panel, wherein the pixel structure comprises a plurality of subpixels, each subpixel in the plurality of subpixels comprises a plurality of sub-subpixels, and the method comprises:

generating at least one control signal;
sending the at least one control signal to a first subpixel, wherein the first subpixel is any subpixel in the plurality of subpixels; and
the at least one control signal indicates to control one or more sub-subpixels in a plurality of sub-subpixels comprised in the first subpixel to emit light.

18. The method according to claim 17, wherein the method further comprises:

determining whether a display gray scale of the first subpixel is less than a first threshold;
generating a first control signal when determining that the display gray scale of the first subpixel is less than the first threshold, wherein the at least one control signal comprises the first control signal; and

sending the first control signal to the first subpixel, wherein the first control signal indicates to control a first sub-subpixel to emit light, and the first sub-subpixel is a sub-subpixel with a smallest light emitting area in the plurality of sub-subpixels comprised in the first subpixel.

19. The method according to claim 18, wherein the first subpixel comprises the first sub-subpixel and a second sub-subpixel, a light emitting area of the second sub-subpixel is greater than the light emitting area of the first sub-subpixel, and the method further comprises:

generating a second control signal when determining that the display gray scale of the first subpixel is greater than or equal to the first threshold and less than a second threshold, wherein the at least one control signal comprises the second control signal; and

sending the second control signal to the first subpixel, wherein the second control signal indicates to control the second sub-subpixel to emit light; and

the second threshold is greater than the first threshold.

20. The method according to claim 19, wherein the first control signal indicates to turn off a switch corresponding to another sub-subpixel other than the first sub-subpixel, and the second control signal is for turning off a switch corresponding to another sub-subpixel other than the second sub-subpixel.

21. The method according to claim 19, wherein the method further comprises:

generating a third control signal when determining that the display gray scale of the first subpixel is greater than or equal to the second threshold, wherein the at least one control signal comprises the third control signal; and

sending the third control signal to the first subpixel, wherein the third control signal indicates to control all the plurality of sub-subpixels to emit light.

22. The method according to claim 21, wherein the first control signal comprises an enable signal for turning on a switch corresponding to the first sub-subpixel, and the second control signal comprises an enable signal for turning on a switch corresponding to the second sub-subpixel, and the third control signal comprises a plurality of enable signals for turning on switches corresponding to the plurality of sub-subpixels, wherein the plurality of enable signals are in a one-to-one correspondence with the plurality of sub-subpixels.

23. The method according to any one of claims 17 to 22, wherein the self-luminous display panel comprises an organic light emitting diode OLED display panel, an active matrix organic light emitting diode AMOLED display panel, or a micro light emitting diode micro LED display panel.

24. A terminal, wherein the terminal comprises the self-luminous display panel according to claim 9 and the display control apparatus according to any one of claims 10 to 16.

25. A computer-readable storage medium, wherein the computer-readable storage medium stores instructions, and when the instructions are run on a computer or a processor, the computer or the processor is enabled to perform the method according to any one of claims 17 to 23.

26. A computer program product comprising instructions, wherein when the computer program product is run on a computer or a processor, the computer or the processor is enabled to perform the method according to any one of claims 17 to 23.

Pixel definition layer

R subpixel      G subpixel      B subpixel

Cathode layer

Organic light emitting layer

Partition layer

Anode layer

R1 anode

R2 anode

Drive layer

Substrate layer

FIG. 1

Cathode layer

Organic light emitting layer

Anode layer

First anode      Second anode

FIG. 2

Pixel definition
layer

Cathode
layer

Partition
layer

Cathode
layer

Pixel definition
layer

Organic
light
emitting
layer

Organic
light
emitting
layer

301

302

Organic
light
emitting
layer

First
anode

Second
anode

Substrate

FIG. 3

Subpixel

Second anode

First anode

Spacing

FIG. 4a

Pixel definition layer     Partition layer     Pixel definition layer

First anode     Second anode     Substrate layer

FIG. 4b

ELVDD

Vdata

EM2

502

503

EM1

501

504

505

ELVSS

FIG. 5

Pixel definition
layer

Partition layer

Partition layer

Pixel definition
layer

First anode

Second anode

Third anode

Substrate

FIG. 6

Pixel 1

Pixel 2

Pixel 3

| R | G | B |
| R | G | B |
| R | G | B |

FIG. 7a

FIG. 7b

FIG. 7c

812      807    808      809     810    812

806      811

802      803      804      805      801

FIG. 8

900

| Processor | SRAM | Microcontroller unit MCU | ROM |

Bus

| Transmission interface | Security subsystem | WLAN subsystem |

FIG. 9

S1001: Generate at least one control signal

S1002: Send the at least one control signal to a first subpixel, where the first subpixel is any subpixel in a plurality of subpixels of a pixel structure, and the at least one control signal indicates to control one or more sub-subpixels in a plurality of sub-subpixels included in the first subpixel to emit light

FIG. 10

S1101: Determine whether a display gray scale of a first subpixel is less than a first threshold, where the first subpixel is any subpixel in a plurality of subpixels

S1102: Send a first control signal to the first subpixel when determining that the display gray scale of the first subpixel is less than the first threshold, where the first control signal indicates to control a first sub-subpixel to emit light, and the first sub-subpixel is a sub-subpixel with a smallest light emitting area in a plurality of sub-subpixels included in the first subpixel

S1103: Send a second control signal to the first subpixel when determining that the display gray scale of the first subpixel is greater than or equal to the first threshold and is less than a second threshold, where the second control signal indicates to control a second sub-subpixel to emit light

S1104: Send a third control signal to the first subpixel when determining that the display gray scale of the first subpixel is greater than or equal to the second threshold, where the third control signal indicates to control all the plurality of sub-subpixels to emit light

FIG. 11

Display control apparatus
1200

Determining
unit 1210

Sending unit 1220

FIG. 12

**COLOR COORDINATES OF A GREEN SUBPIXEL**

Original
CIE x

Original
CIE y

AR' 4 CIE x

AR' 4
CIE y

AR' 10
CIE x

AR' 10 CIE y

CIEX & CIEY

0.8000
0.7000
0.6000
0.5000
0.4000
0.3000
0.2000
0.1000
0.0000

0.01    0.02    0.03    0.06    0.13    0.25    0.50    1.00    2.00    4.00

LUMINANCE OF A DISPLAY SCREEN

FIG. 13

## INTERNATIONAL SEARCH REPORT

| International application No. |
| --- |
| **PCT/CN2020/138928** |

| A. | CLASSIFICATION OF SUBJECT MATTER |
| --- | --- |
| | G09G 3/32(2016.01)i |

According to International Patent Classification (IPC) or to both national classification and IPC

| B. | FIELDS SEARCHED |
| --- | --- |

Minimum documentation searched (classification system followed by classification symbols)

G09G 3/-

Documentation searched other than minimum documentation to the extent that such documents are included in the fields searched

Electronic data base consulted during the international search (name of data base and, where practicable, search terms used)

CNPAT, CNKI, WPI, EPODOC: 子像素, 亚像素, 分割, 隔断, 隔开, 独立, 单独, 发光, 低灰阶, 灰度, 亮度, 均匀, 色偏, sub 1w pixel, divide, fragment, separate, independent, alone, single, light, low, gray, grey, brightness, even, chromatic

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 104077966 A (JAPAN DISPLAY, INC.) 01 October 2014 (2014-10-01) description, paragraphs [0107]-[0124], and figures 10-11 | 1-26 |
| A | CN 102820000 A (GLOBAL OLED TECHNOLOGY LLC.) 12 December 2012 (2012-12-12) entire document | 1-26 |
| A | CN 104835468 A (SHENZHEN CHINA STAR OPTOELECTRONICS TECHNOLOGY CO., LTD.) 12 August 2015 (2015-08-12) entire document | 1-26 |
| A | CN 107275360 A (LG DISPLAY CO., LTD.) 20 October 2017 (2017-10-20) entire document | 1-26 |
| A | KR 20140017225 A (LG DISPLAY CO., LTD.) 11 February 2014 (2014-02-11) entire document | 1-26 |
| A | US 2007058115 A1 (UTSUMI, Yuka et al.) 15 March 2007 (2007-03-15) entire document | 1-26 |
| A | US 2015241750 A1 (SAMSUNG DISPLAY CO., LTD.) 27 August 2015 (2015-08-27) entire document | 1-26 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **31 August 2021** | **26 September 2021** |

| Name and mailing address of the ISA/CN | Authorized officer |
| --- | --- |
| China National Intellectual Property Administration (ISA/CN) No. 6, Xitucheng Road, Jimenqiao, Haidian District, Beijing 100088, China | |
| Facsimile No. (86-10)62019451 | Telephone No. |

Form PCT/ISA/210 (second sheet) (January 2015)

<div style="text-align:center">

**INTERNATIONAL SEARCH REPORT**
Information on patent family members

</div>

International application No.

**PCT/CN2020/138928**

| Patent document cited in search report | | | Publication date (day/month/year) | Patent family member(s) | | | Publication date (day/month/year) |
|---|---|---|---|---|---|---|---|
| CN | 104077966 | A | 01 October 2014 | CN | 106918944 | A | 04 July 2017 |
| | | | | JP | 2014186283 | A | 02 October 2014 |
| | | | | US | 10025145 | B2 | 17 July 2018 |
| | | | | US | 2014285761 | A1 | 25 September 2014 |
| | | | | KR | 20140116806 | A | 06 October 2014 |
| | | | | US | 9507203 | B2 | 29 November 2016 |
| | | | | TW | 201441731 | A | 01 November 2014 |
| | | | | JP | 5827970 | B2 | 02 December 2015 |
| | | | | KR | 101630030 | B1 | 13 June 2016 |
| | | | | CN | 111679477 | A | 18 September 2020 |
| | | | | US | 2017045786 | A1 | 16 February 2017 |
| | | | | CN | 106918944 | B | 12 March 2021 |
| | | | | TW | I533053 | B | 11 May 2016 |
| | | | | CN | 104077966 | B | 12 April 2017 |
| CN | 102820000 | A | 12 December 2012 | EP | 2209105 | B1 | 17 September 2014 |
| | | | | CN | 101573743 | A | 04 November 2009 |
| | | | | US | 8013817 | B2 | 06 September 2011 |
| | | | | CN | 102820000 | B | 01 April 2015 |
| | | | | JP | 2010515102 | A | 06 May 2010 |
| | | | | EP | 2100287 | A1 | 16 September 2009 |
| | | | | EP | 2209105 | A2 | 21 July 2010 |
| | | | | WO | 2008079197 | A1 | 03 July 2008 |
| | | | | US | 2008158107 | A1 | 03 July 2008 |
| | | | | JP | 5254991 | B2 | 07 August 2013 |
| | | | | EP | 2100287 | B1 | 28 August 2013 |
| CN | 104835468 | A | 12 August 2015 | US | 2017098419 | A1 | 06 April 2017 |
| | | | | WO | 2016183864 | A1 | 24 November 2016 |
| | | | | CN | 104835468 | B | 13 February 2018 |
| | | | | US | 9972256 | B2 | 15 May 2018 |
| CN | 107275360 | A | 20 October 2017 | CN | 107275360 | B | 16 October 2020 |
| | | | | US | 10236326 | B2 | 19 March 2019 |
| | | | | US | 2019157361 | A1 | 23 May 2019 |
| | | | | US | 2017287988 | A1 | 05 October 2017 |
| | | | | EP | 3226301 | A1 | 04 October 2017 |
| KR | 20140017225 | A | 11 February 2014 | KR | 101904472 | B1 | 04 October 2018 |
| US | 2007058115 | A1 | 15 March 2007 | US | 8208099 | B2 | 26 June 2012 |
| | | | | JP | 2007078771 | A | 29 March 2007 |
| | | | | JP | 4585411 | B2 | 24 November 2010 |
| US | 2015241750 | A1 | 27 August 2015 | KR | 20150099665 | A | 01 September 2015 |

Form PCT/ISA/210 (patent family annex) (January 2015)